(19) Europäisches Patentamt
European Patent Office
Office européen des brevets

(11) **EP 3 932 687 A1**

(12) **EUROPEAN PATENT APPLICATION**
published in accordance with Art. 153(4) EPC

(43) Date of publication:
**05.01.2022 Bulletin 2022/01**

(21) Application number: **20762820.7**

(22) Date of filing: **25.02.2020**

(51) Int Cl.:
**B41N 1/12** *(2006.01)*    **B41N 3/00** *(2006.01)*
**G03F 7/00** *(2006.01)*    **G03F 7/004** *(2006.01)*
**G03F 7/032** *(2006.01)*    **G03F 7/095** *(2006.01)*
**G03F 7/11** *(2006.01)*

(86) International application number:
**PCT/JP2020/007295**

(87) International publication number:
**WO 2020/175422 (03.09.2020 Gazette 2020/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.02.2019 JP 2019034366**
**07.05.2019 JP 2019087410**

(71) Applicant: **Asahi Kasei Kabushiki Kaisha**
**Tokyo 1000006 (JP)**

(72) Inventors:
• **TOYOOKA, Sota**
  **Tokyo 100-0006 (JP)**
• **FUJIKI, Yuzo**
  **Tokyo 100-0006 (JP)**

(74) Representative: **Strehl Schübel-Hopf & Partner**
**Maximilianstrasse 54**
**80538 München (DE)**

(54) **FLEXOGRAPHIC PRINTING ORIGINAL PLATE, AND METHOD FOR MANUFACTURING FLEXOGRAPHIC PRINTING PLATE**

(57) A flexographic printing raw plate comprising at least a support, a photosensitive resin composition layer, an infrared ablation layer, and a cover film sequentially stacked, wherein the infrared ablation layer contains an infrared absorber, a binder polymer, and a dispersant, and a base number of the dispersant is 5 to 100 mgKOH/g.

**Description**

Technical Field

The present invention relates to a flexographic printing raw plate and a manufacturing method of a flexographic printing plate.

Background Art

In technology for manufacturing flexographic printing plate, computer to plate (CTP) technology has been developed recently.

In the CTP technology, a sheet in which a photosensitive resin composition layer, an infrared ablation layer, and a cover film are stacked in sequence on a substrate such as PET resin is usually used as a raw plate for flexographic printing plate manufacturing.

Production of a flexographic printing plate is carried out in the following manner, for example.

Firstly, a uniform cured layer is formed by performing back exposure in which the entire surface of a photosensitive resin composition layer is irradiated with ultraviolet light through the substrate.

Then, the cover film on the infrared ablation layer is peeled to expose the infrared ablation layer, and lithography is performed by irradiation with a laser to remove a part of the infrared ablation layer, thereby producing an image mask.

Furthermore, relief exposure in which the photosensitive resin composition layer is irradiated with ultraviolet light through the image mask is performed to photocure the part at which the infrared ablation layer has been removed.

Thereafter, the unexposed part (that is, the part not photocured) of the photosensitive resin composition layer is removed to form a relief image, which is a desired image, and a flexographic printing plate is thus obtained.

The infrared ablation layer usually contains a binder polymer and an infrared absorber which is a material opaque to radial rays.

The infrared ablation layer is to be ablated by an infrared laser and therefore is preferably a thinner layer in view of ablation efficiency.

On the other hand, the infrared ablation layer has a function as a mask layer for inhibiting penetration of chemoradial rays into the photosensitive resin composition layer and therefore is required to have at least a certain level of light shielding properties.

It is also important that the infrared ablation layer have no defect (pin hole).

When the infrared ablation layer has a pin hole, the photosensitive resin composition layer adjacent to the pin hole is exposed at the time of performing relief exposure, causing an unintended image to be formed; consequently, the following problems arise: micro dots cannot be formed, and relief with a shallow relief depth is formed contrary to intention.

An infrared ablation layer is usually formed by laminating, on a photosensitive resin composition layer, a stack for forming the infrared ablation layer with the infrared ablation layer side facing the photosensitive resin composition layer to transfer the infrared ablation layer and to stack the infrared ablation layer on the photosensitive resin composition layer.

The stack for forming the infrared ablation layer is manufactured by forming the infrared ablation layer on a support (cover film) by coating, for example.

In manufacturing the stack for forming the infrared ablation layer, a defect (pin hole) may be generated in the infrared ablation layer due to uneven coating or cissing occurring when the infrared ablation layer is made on the support (cover film) by coating.

At the time of laminating the stack for forming the infrared ablation layer and the photosensitive resin composition layer, a pin hole may be generated in the infrared ablation layer due to the temperature or pressure at lamination or by pressing the infrared ablation layer together with a photosensitive resin composition kneaded and extruded.

In view of the above-described circumstances, a technique involving using a styrene-conjugated diene copolymer (see Patent Document 1 below, for example) and a technique involving using a butyral resin and a polar group-containing polyamide (see Patent Document 2 below, for example) as a binder polymer have been heretofore suggested for preventing a defect (pin hole) from generating in the infrared ablation layer so as to realize an infrared ablation layer having good infrared absorber dispersibility in the infrared ablation layer, not causing uneven coating and cissing when the infrared ablation layer is formed on a support by coating, and further having high scratch resistance.

Incidentally, the stack for forming the infrared ablation layer is stored in a state of a web roll or a state of a plurality of sheet-like materials cut into an arbitrary and superposed on one another.

During storage of the stack for forming the infrared ablation layer, the surface of the infrared ablation layer contacts with the back surface of the support or a protective film such as polyethylene. In this state, pressure due to gravity is applied to the contact surface. Therefore, a trouble in which the surface of the infrared ablation layer sticks to the back surface of the support or the protective film and peels off may be caused.

In view of the above-described circumstances, a technique for preventing the trouble in which the infrared ablation layer sticks to the back surface of the support or the protective film and peels off by precipitating a fatty acid amide on the surface of the infrared ablation layer (see Patent Document 3 below, for example) has been suggested.

List of Prior Art Documents

Patent Document

Patent Document 1: Japanese Patent No. 4080068
Patent Document 2: Japanese Patent No. 4200510
Patent Document 3: Japanese Patent No. 6232279

Summary of Invention

Problems to be Solved by Invention

However, there are other causes of pin hole generation in the infrared ablation layer besides the causes of pin hole generation described above, and pin hole generation has not been sufficiently prevented in conventional techniques.

For example, in a case where adhesive strength between the cover film and the infrared ablation layer is high, the cover film cannot be peeled normally at the time of exposing the infrared ablation layer by peeling the cover film and a pin hole may be generated, in manufacturing a flexographic printing plate.

In addition, depending on the humidity and temperature of an environment during storage of the flexographic printing raw plate, adhesive strength between the cover film and the infrared ablation layer may further increase. In such a case, possibility of causing a defect may increase when the cover film is peeled from the infrared ablation layer.

Further, the technologies using the binder polymers suggested in Patent Documents 1 and 2 are excellent in the effect of improving scratch resistance of the infrared ablation layer but has the following problem: adhesive strength between the cover film and the infrared ablation layer increases depending on an environment during storage, and a defect may be generated in the infrared ablation layer when separating the cover film and the infrared ablation layer.

Furthermore, the stack for forming the infrared ablation layer with a fatty acid polyamide precipitated on the surface suggested in Patent Document 3 has the effect of suppressing adhesion with the back surface of the support (cover film) or the protective film mounted on the top surface of the infrared ablation layer, but has no effect of suppressing adhesion between the support (cover film) and the infrared ablation layer. The stack also has the following problem: adhesive strength between the support (cover film) and the infrared ablation layer increases depending on the environment during storage, and a defect may be generated in the infrared ablation layer when separating the cover film and the infrared ablation layer.

Therefore, giving consideration to the problems in conventional techniques, the present invention aims at providing a flexographic printing raw plate which is excellent in pin hole resistance (hereinafter, sometimes referred to as PH resistance) of an infrared ablation layer and in which a cover film on the infrared ablation layer is easily peeled independent of the environment during storage, and a manufacturing method of a flexographic printing plate using the flexographic printing raw plate.

Means for Solving Problems

The present inventors have made intensive studies to solve the above-described problems, and as a result, have found that the above-described problems can be solved by a flexographic printing raw plate having an infrared ablation layer which contains an infrared absorber, a binder polymer, and a dispersant, the dispersant having a base number within a predetermined numerical range.
Thus, the present invention has been accomplished.

Specifically, the present invention is as follows.

[1] A flexographic printing raw plate comprising at least a support, a photosensitive resin composition layer, an infrared ablation layer, and a cover film sequentially stacked, wherein

the infrared ablation layer contains an infrared absorber, a binder polymer, and a dispersant, and
a base number of the dispersant is 5 to 100 mgKOH/g.

[2] The flexographic printing raw plate according to [1] above, wherein
an absolute value of a difference between solubility parameters (SP values) of the binder polymer and the dispersant is 0.3 to 4 $(cal/cm^3)^{1/2}$.

[3] The flexographic printing raw plate according to [1] or [2] above, wherein
the infrared absorber is carbon black.

[4] The flexographic printing raw plate according to any one of [1] to [3] above, wherein
a weight average molecular weight of the dispersant measured by gel permeation chromatography (GPC) in terms of standard polystyrene is 1000 or more and 10000 or less.

[5] The flexographic printing raw plate according to any one of [1] to [4] above, wherein
the infrared ablation layer contains 0.5 to 50 parts by mass of the dispersant per 100 parts by mass of the infrared absorber.

[6] The flexographic printing raw plate according to any one of [1] to [5] above, wherein

the binder polymer includes at least one selected from the group consisting of
a thermoplastic elastomer including a copolymer of a monovinyl-substituted aromatic hydrocarbon monomer and a conjugated diene monomer, a hydrogenated product of the copolymer,
a polyamide, a polybutyral, a polyvinyl alcohol, a poly(meth)acrylate, and a modification product or partially saponified product thereof.

[7] The flexographic printing raw plate according to any one of [1] to [6] above, further comprising an intermediate layer including an adhesive layer or an oxygen inhibiting layer between the photosensitive resin composition layer and the infrared ablation layer.

[8] A manufacturing method of a flexographic printing plate, comprising the steps of:

irradiating the flexographic printing raw plate according to any one of [1] to [6] above with ultraviolet light from a side of the support;
irradiating the infrared ablation layer with infrared light to form a pattern by lithography,
irradiating the photosensitive resin composition layer with ultraviolet light for pattern exposure, and
removing unexposed parts of the infrared ablation layer and the photosensitive resin composition layer.

[9] A manufacturing method of a flexographic printing plate, comprising the steps of:

irradiating the flexographic printing raw plate according to [7] above with ultraviolet light from a side of the support;
irradiating the infrared ablation layer with infrared light to form a pattern by lithography,
irradiating the photosensitive resin composition layer with ultraviolet light for pattern exposure, and
removing unexposed parts of the infrared ablation layer, the intermediate layer and the photosensitive resin composition layer.

Advantages of Invention

According to the present invention, a flexographic printing raw plate which is excellent in pin hole resistance of an infrared ablation layer and in which a cover film on the infrared ablation layer is easily peeled independent of the environment during storage, and a manufacturing method of a flexographic printing plate using the flexographic printing raw plate can be provided.

Mode for Carrying Out Invention

Hereinafter, a mode for carrying out the present invention (hereinafter, referred to as the "present embodiment") will be described in detail. However, the present invention is not limited thereto, and various modifications can be made without departing from the spirit of the present invention.

[Flexographic printing raw plate]

The flexographic printing raw plate of the present embodiment includes at least a support, a photosensitive resin composition layer, an infrared ablation layer, and a cover film sequentially stacked, in which the infrared ablation layer contains an infrared absorber, a binder polymer, and a dispersant, and the base number of the dispersant is 5 to 100 mgKOH/g.

(Support)

The support used for the flexographic printing raw plate of the present embodiment is not particularly limited, and examples thereof include a polypropylene film, a polyethylene film, a film of a polyester such as polyethylene terephthalate and polyethylene naphthalate, and a polyamide film.

As the support, a dimensionally stable film with a thickness of 75 $\mu$m to 300 $\mu$m is preferable, and a polyester film is especially preferable.

In addition, an adhesive layer is preferably provided on the support.

Examples of material for the adhesive layer include a resin composition containing a binder polymer such as polyurethane, polyamide, and a thermoplastic elastomer and an adhesive active ingredient such as an isocyanate compound and an ethylenically unsaturated compound.

Furthermore, various auxiliary additive components such as a plasticizer, a thermal-polymerization preventing agent, an ultraviolet absorber, a halation preventing agent, a photostabilizer, a photopolymerization initiator, a photopolymerizable monomer, and a dye can be added to the adhesive layer.

It is more preferable that at least one or more undercoating layers be provided, in view of obtain greater adhesive strength between the adhesive layer and the support.

(Photosensitive resin composition layer)

The photosensitive resin composition layer included in the flexographic printing raw plate of the present embodiment is useful for any of solvent development, water development, and heat development.

Preferable examples of material for the photosensitive resin composition layer include a photosensitive resin composition including (a) a thermoplastic elastomer, (c) a photopolymerizable monomer, and (d) a photopolymerization initiator.

When a development step is performed in an aqueous cleaning liquid, it is preferable that the photosensitive resin composition layer further include (b) a hydrophilic copolymer.

Those described in "Japanese Patent Laid-Open No. 2018-120131" can be used as the compounds (a) to (d) described above, for example.

<(a) Thermoplastic elastomer>

The thermoplastic elastomer (a) is preferably a thermoplastic elastomer containing at least one polymer block containing mainly a conjugated diene and at least one polymer block containing mainly a vinyl aromatic hydrocarbon.

The term "containing mainly" used herein means accounting for 60% by mass or more of the polymer block.

In the polymer block containing mainly a conjugated diene, the conjugated diene preferably accounts for 80% by mass or more and more preferably 90% by mass or more of the polymer block.

Examples of the conjugated diene include, but not limited to, monomers such as 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene, and 1,3-butadiene is especially preferable in view of abrasion resistance. These monomers may be used singly or in combinations of two or more thereof.

A vinyl content in the total amount of the conjugated diene of the polymer block containing mainly the conjugated diene, a content of 1,2-butadiene or 3,4-isoprene, for example, is not particularly limited. The vinyl content is preferably 5 mol% to 50 mol%, more preferably 8 mol% to 50 mol%, and still more preferably 10 mol% to 40 mol% in view of printing plate formability.

A number average molecular weight of the polymer block containing mainly the conjugated diene is preferably 20,000 to 250,000, more preferably 30,000 to 200,000, and still more preferably 40,000 to 150,000 in view of printing durability of the plate.

The polymer block containing mainly the conjugated diene may contain an alkylene unit. An introducing method of the alkylene unit is not particularly limited, and examples thereof include a method involving polymerization using a monoolefin such as ethylene and butylene as a starting material monomer of the polymer block containing mainly the conjugated diene, and a method involving hydrogenating conjugated diene polymer block. Especially, a method involving hydrogenating polymer block containing mainly the conjugated diene is preferable in view of availability.

The content of the alkylene unit in the polymer block containing mainly a conjugated diene is preferably 5 mol% or more in view of solvent resistance and is preferably 50 mol% or less in view of ensuring transparency of the photosensitive resin composition. The content is more preferably in a range of 10 mol% to 35 mol%, and still more preferably in a range of 10 mol% to 25 mol%.

The alkylene unit is preferably contained in a polymer block containing mainly butadiene. It is more preferable that the polymer block moiety containing mainly butadiene be hydrogenated so as to contain all of a 1,4-butadiene unit, a 1,2-butadiene(vinyl) unit, and a butylene (alkylene) unit. It is further preferable that the polymer block containing mainly butadiene contain at least a 1,4-butadiene unit, a 1,2-butadiene(vinyl) unit, and a butylene unit in ranges of 25 mol% to 70 mol%, 0 mol% to 50 mol%, and 10 mol% to 50 mol%, respectively.

The conjugated diene content, the vinyl content in the conjugated diene, and the content and ratio of the vinyl aromatic hydrocarbon can be measured using a nuclear magnetic resonance device ($^1$H-NMR).

Examples of the vinyl aromatic hydrocarbon include monomers such as styrene, t-butylstyrene, divinylbenzene, 1,1-diphenylstyrene, N,N-dimethyl-p-aminoethyl styrene, N,N-diethyl-p-aminoethyl styrene, vinylpyridine, p-methylstyrene, tertiary butylstyrene, α-methylstyrene, and 1,1-diphenylethylene. Especially, styrene is preferable because a flexographic printing raw plate with smoothness can be formed at a relatively low temperature (hereinafter, referred to as high smoothness). These monomers may be used singly, or in combinations of two or more thereof.

A number average molecular weight of the polymer block containing mainly the vinyl aromatic hydrocarbon is preferably 100,000 or less in view of preventing orientation of a printing plate from being exhibited and is preferably 3,000 or more in view of chipping resistance during plate making and printing. The number average molecular weight of the polymer block containing mainly the vinyl aromatic hydrocarbon is more preferably within a range of 5,000 to 80,000 and still more preferably within a range of 5,000 to 60,000.

The content of the vinyl aromatic hydrocarbon in the block copolymer is preferably 25% by mass or less in view of high smoothness of the photosensitive resin composition, high chipping resistance at a convex part of the printing plate, and keeping hardness of the printing plate high when an ink component attaches thereto. On the other hand, the content is preferably 13% by mass or more in view of enhancing cold flow resistance of the flexographic printing raw plate of the present embodiment. The content is more preferably in a range of 15% by mass to 24% by mass, and still more preferably in a range of 16% by mass to 23% by mass.

The content of the thermoplastic elastomer (a) in the photosensitive resin composition layer is preferably 15% by mass to 90% by mass based on 100% by mass of the total amount of the photosensitive resin composition in view of printing durability of the plate during printing. The content of the thermoplastic elastomer (a) is more preferably 15% by mass to 80% by mass and still more preferably 20% by mass to 75% by mass.

<(b) Hydrophilic copolymer>

The hydrophilic copolymer (b) is internally-crosslinked polymer particles containing a unit derived from a hydrophilic unsaturated monomer. Examples of the polymer particles include those obtained by removing water from a water-dispersion latex in which polymer particles as a dispersoid are dispersed in water, the polymer particles being obtained by subjecting a hydrophilic unsaturated monomer and optionally another monomer capable of being copolymerized therewith to emulsion polymerization. The amount of the unit derived from a hydrophilic unsaturated monomer may be 0.1% to 20% by mass, 0.5% to 15% by mass, or 1% to 10% by mass based on the total monomers, for example.

The hydrophilic unsaturated monomer is preferably a monomer containing at least one hydrophilic group and an unsaturated double bond. Examples of the hydrophilic unsaturated monomer include a monomer containing an unsaturated double bond and containing any of a carboxylic acid group, a sulfonic acid group, a phosphoric acid group, and the like, salts thereof, and an acid anhydride group; a monomer containing a hydroxy group and an unsaturated double bond; a monomer containing an acrylamide and an unsaturated double bond; and a surfactant (monomer) containing a reactive unsaturated double bond. These hydrophilic unsaturated monomers may be used singly, or two or more thereof may be used.

Examples of the water-dispersion latex include a latex polymer dispersed in water such as an acrylonitrile-butadiene copolymer latex, a polychloroprene latex, a polyisoprene latex, a polyurethane latex, a (meth)acrylate-butadiene latex, a vinylpyridine polymer latex, a butyl polymer latex, a Thiokol polymer latex, and an acrylate polymer latex.

In addition, a latex polymer dispersed in water in which any of these water-dispersion latexes is copolymerized with one or more of (meth)acrylate and unsaturated monomers containing an acidic functional group is preferable, examples of the unsaturated monomer including monobasic acids including carboxylic acids such as acrylic acid, methacrylic acid, crotonic acid, vinylbenzoic acid, and cinnamic acid and sulfonic acids such as styrene sulfonic acid; and dibasic acids such as itaconic acid, fumaric acid, maleic acid, citraconic acid, and muconic acid.

The water-dispersion latex may further include other polymer particles as a dispersoid in addition to polymer particles obtained by subjecting a hydrophilic unsaturated monomer and optionally another monomer capable of being copolymerized therewith to emulsion polymerization. Examples of such other polymer particles include particles of polybutadiene, natural rubber, and a styrene-butadiene copolymer.

Among these water-dispersion latexes, a water-dispersion latex containing a butadiene skeleton or an isoprene skeleton in a molecular chain of the polymer is preferable in view of printing durability of the plate. For example, polybutadiene latex, styrene-butadiene copolymer latex, acrylonitrile-butadiene copolymer latex, and those obtained by copolymerizing any of these water-dispersion latexes with a (meth)acrylic acid ester, acrylic acid, methacrylic acid, itaconic acid, and the like are preferable. The water-dispersion latex is more preferably a water-dispersion latex of a copolymer in which one or more unsaturated monomers containing an acidic functional group such as a (meth)acrylic acid ester, acrylic acid, methacrylic acid, and itaconic acid are copolymerized with a styrene-butadiene copolymer.

An amount used of the unsaturated monomer containing an acidic functional group is preferably 1% to 30% by mass based on the total amount of unsaturated monomers used for synthesizing the hydrophilic copolymer (b). When the amount used is 1% by mass or more, aqueous developing tends to be easier. When the amount used is 30% by mass or less, an increase in the amount of moisture absorbed by the photosensitive resin composition and an increase in swelling by ink can be prevented, and deterioration in processability during mixing the photosensitive resin composition can be prevented.

Examples of an unsaturated monomer other than the unsaturated monomer containing an acidic functional group available for the synthesis of the hydrophilic copolymer (b) include, but not limited to, conjugated dienes, aromatic vinyl compounds, (meth)acrylic acid esters, ethylene-based monocarboxylic acid alkyl ester monomers having a hydroxy group, unsaturated dibasic acid alkyl esters, maleic anhydride, vinyl cyanide compounds, (meth)acrylamides and derivatives thereof, vinyl esters, vinyl ethers, vinyl halides, basic monomers having an amino group, vinylpyridine, olefins, silicon-containing α,β-ethylenically unsaturated monomers, and allyl compounds.

Examples of the conjugated dienes include, but not limited to, 1,3-butadiene, isoprene, 2,3-dimethyl-1,3-butadiene, 2-ethyl-1,3-butadiene, 2-methyl-1,3-butadiene, 1,3-pentadiene, chloroprene, 2-chloro-1,3,-butadiene, and cyclopentadiene.

Examples of the aromatic vinyl compounds include, but not limited to, styrene, α-methylstyrene, o-methylstyrene, m-methylstyrene, p-methylstyrene, ethylstyrene, vinyltoluene, vinylxylene, bromostyrene, vinylbenzyl chloride, p-t-butylstyrene, chlorostyrene, alkylstyrene, divinylbenzene, and trivinylbenzene.

Examples of the (meth)acrylic acid esters include, but not limited to, methyl (meth)acrylate, ethyl (meth)acrylate, propyl (meth)acrylate, n-butyl (meth)acrylate, t-butyl (meth)acrylate, isobutyl (meth)acrylate, n-amyl (meth)acrylate, isoamylhexyl (meth)acrylate, octyl (meth)acrylate, nonyl (meth)acrylate, decyl (meth)acrylate, dodecyl (meth)acrylate, octadecyl (meth)acrylate, cyclohexyl (meth)acrylate, phenyl (meth)acrylate, benzyl (meth)acrylate, 2-ethyl-hexyl (meth)acrylate, hydroxyethyl (meth)acrylate, hydroxypropyl (meth)acrylate, hydroxycyclohexyl (meth)acrylate, glycidyl (meth)acrylate, ethylene glycol di(meth)acrylate, ethylene glycol di(meth)acrylate, 1,3-butylene glycol di(meth)acrylate, 1,4-butylene glycol di(meth)acrylate, propylene glycol di(meth)acrylate, 1,5-pentanediol di(meth)acrylate, neopentyl glycol di(meth)acrylate, 1,6-hexanediol di(meth)acrylate, diethylene glycol di(meth)acrylate, triethylene glycol di(meth)acrylate, tetraethylene glycol di(meth)acrylate, polyethylene glycol di(meth)acrylate, polypropylene glycol di(meth)acrylate, pentaerythritol tri(meth)acrylate, trimethylolpropane tri(meth)acrylate, tetramethylolmethane tetra(meth)acrylate, allyl (meth)acrylate, bis(4-acryloxypolyethoxyphenyl)propane, methoxy polyethylene glycol (meth)acrylate, β-(meth)acryloyloxy ethylhydrogenphthalate, β-(meth)acryloyloxy ethylhydrogensuccinate, 3-chloro-2-hydroxypropyl (meth)acrylate, stearyl (meth)acrylate, phenoxyethyl (meth)acrylate, phenoxypolyethyleneglycol (meth)acrylate, 2-hydroxy-1,3-di(meth)acryloxypropane, 2,2-bis[4-((meth)acryloxyethoxy)phenyl]propane, 2,2-bis[4-((meth)acryloxy-diethoxy)phenyl]propane, 2,2-bis[4-((meth)acryloxy-polyethoxy)phenyl]propane, and isobornyl (meth)acrylate.

Examples of the ethylene-based monocarboxylic acid alkyl ester monomers having a hydroxy group include, but not limited to, 2-hydroxyethyl acrylate, 2-hydroxyethyl methacrylate, 2-hydroxypropyl acrylate, 2-hydroxypropyl methacrylate, 1-hydroxypropyl acrylate, 1-hydroxypropyl methacrylate, and hydroxycyclohexyl (meth)acrylate.

Examples of the unsaturated dibasic acid alkyl esters include, but not limited to, alkyl crotonates, alkyl itaconates, alkyl fumarates, and alkyl maleates.

Examples of the vinyl cyanide compounds include, but not limited to, acrylonitrile and methacrylonitrile.

Examples of the (meth)acrylamides and derivatives thereof include, but not limited to, (meth)acrylamide, N-methylol (meth)acrylamide, and N-alkoxy (meth)acrylamide.

Examples of the vinyl esters include, but not limited to, vinyl acetate, vinyl butyrate, vinyl stearate, vinyl laurate, vinyl myristate, vinyl propionate, and vinyl ester of versatic acid.

Examples of the vinyl ethers include, but not limited to, methyl vinyl ether, ethyl vinyl ether, propyl vinyl ether, butyl vinyl ether, amyl vinyl ether, and hexyl vinyl ether.

Examples of the vinyl halides include, but not limited to, vinyl chloride, vinyl bromide, vinyl fluoride, vinylidene chloride, and vinylidene fluoride.

Examples of the basic monomers having an amino group include, but not limited to, aminoethyl (meth)acrylate, dimethylaminoethyl (meth)acrylate, and diethylaminoethyl (meth)acrylate.

Examples of the olefins include, but not limited to, ethylene.

Examples of the silicon-containing α,β-ethylenically unsaturated monomers include, but not limited to, vinyltrichlorosilane and vinyltriethoxysilane.

Examples of the allyl compounds include, but not limited to, allyl esters and diallyl phthalates.

Besides, a monomer having three or more double bonds such as triallyl isocyanurate can be also used.

These monomers may be used singly, or two or more thereof may be mixed and used. The mass ratio between the unsaturated monomer containing an acidic functional group and the other monomers (unsaturated monomer containing acidic functional group/other monomers) is preferably 5/95 to 95/5 and more preferably 50/50 to 90/10.

When said ratio is 5/95 to 95/5, rubber elasticity of the photosensitive resin composition can be good in practical use.

The hydrophilic copolymer (b) is preferably a polymer synthesized through emulsion polymerization. In this case, an emulsifier (surfactant) used at the time of polymerization is preferably a reactive emulsifier.

The reactive emulsifier is preferably a reactive emulsifier containing a radically polymerizable double bond, a hydrophilic functional group, and a hydrophobic group in its molecular structure and having emulsifying, dispersing, and swelling functions as with common emulsifiers. When the hydrophilic copolymer (b) is prepared by emulsion polymerization, an emulsifier (surfactant) to be use is preferably capable of synthesizing a polymerization product having an average particle diameter of 5 to 500 nm when the reactive emulsifier is used in an amount of 0.1 parts by mass or more per 100 parts by mass of the sum of the unsaturated monomer containing an acidic functional group and the other monomers excluding the reactive emulsifier.

Examples of structure of the radically polymerizable double bond in the molecular structure of the reactive emulsifier include a vinyl group and an acryloyl group or a methacryloyl group.

Examples of the hydrophilic functional group in the molecular structure of the reactive emulsifier include anionic groups such as a sulfate group, a nitrate group, a phosphate group, a borate group, and a carboxy group; cationic groups such as an amino group; polyoxyalkylene chain structure or the like such as polyoxyethylene, polyoxymethylene, and polyoxypropylene; or hydroxy group.

Examples of the hydrophobic group in the molecular structure of the reactive emulsifier include an alkyl group and a phenyl group.

The reactive emulsifier includes an anionic emulsifier, a nonionic emulsifier, a cationic emulsifier, and an amphoteric emulsifier, according to the type of the hydrophilic functional group contained in its structure. The radically polymerizable double bond, the hydrophilic functional group, and the hydrophobic group may each be contained in the molecular structure in a combination of several types.

The commercially available surfactant can be used as the reactive emulsifier. While the commercially available anionic surfactant is not particularly limited, examples thereof include ADEKA REASOAP SE (manufactured by ADEKA Corporation), Aqualon HS, BC, and KH (manufactured by DKS Co. Ltd.), LATEMUL S (manufactured by Kao Corporation), Antox MS (manufactured by Nippon Nyukazai Co., Ltd.), ADEKA REASOAP SDX and PP (manufactured by ADEKA Corporation), Hightenol A (manufactured by DKS Co. Ltd.), ELEMINOL RS (manufactured by Sanyo Chemical Industries, Ltd.), and SPINOMAR (manufactured by Toyo Soda Kogyo Kabushiki Kaisha). While the commercially available nonionic surfactant is not particularly limited, examples thereof include Aqualon RN and Noigen N (manufactured by DKS Co. Ltd.) and ADEKA REASOAP NE (manufactured by ADEKA Corporation).

These may be used singly, or two or more thereof may be used in combination.

The amount of the reactive emulsifier used preferably falls within a range of 1 to 20 parts by mass per 100 parts by mass of the hydrophilic copolymer (b) calculated from the amount of starting materials fed. When the amount of the reactive emulsifier is 1 part by mass or more, image reproducibility of a printing plate obtained tends to improve, and when the amount of the reactive emulsifier is 20 parts by mass or less, printing durability of the printing plate obtained tends to improve.

When the hydrophilic copolymer (b) is synthesized through emulsion polymerization, a non-reactive emulsifier can also be used as needed.

Examples of the non-reactive emulsifier include, but not limited to, anionic surfactants such as fatty acid soap, rosin acid soap, a sulfonate, a sulfate, a phosphate, a polyphosphate, and an acyl sarcosinate; cationic surfactants such as a nitrilated fat or oil derivative, a fat or oil derivative, a fatty acid derivative, and an $\alpha$-olefin derivative; and nonionic surfactants such as an alcohol ethoxylate, an alkylphenol ethoxylate, a propoxylate, a fatty acid alkanolamide, an alkyl polyglycoside, a polyoxyethylene sorbitan fatty acid ester, and an oxyethylene oxypropylene block copolymer. These may be used singly, or two or more thereof may be used in combination.

Examples of the sulfonate include, but not limited to, an alkyl sulfonate, an alkyl sulfate, an alkyl sulfosuccinate, a polyoxyethylene alkyl sulfate, sulfonated fat or oil, an alkyldiphenylether disulfonate, an $\alpha$-olefin sulfonate, an alkyl glyceryl ether sulfonate, and an N-acylmethyltaurate.

Other examples of the non-reactive emulsifier include those described in "Kaimenkasseizai handobukku (Surfactant Handbook) (Takahashi, Namba, Koike, Kobayashi: Kougakutosho Ltd., 1972)."

The amount of the non-reactive emulsifier used is preferably less than 1 part by mass per 100 parts by mass of the hydrophilic copolymer (b) calculated from an amount of starting material fed. When the amount of the non-reactive emulsifier used is less than 1 part by mass, a printing plate to be obtained has an appropriate water swelling ratio, and a decrease of abrasion resistance occurring when ink attaches and a decrease of image reproducibility after absorbing moisture can be prevented.

In a common emulsion polymerization method of the hydrophilic copolymer (b), predetermined amounts of water, an emulsifier, and other additives are fed, in advance, to a reaction system having been adjusted to a temperature at which polymerization is possible, and a polymerization initiator and an unsaturated monomer, an emulsifier, an adjuster, and the like are added into this reaction system by batch operation or continuous operation. In addition, a method in which predetermined amounts of a seed latex, a polymerization initiator, an unsaturated monomer, and another adjuster are added in advance to the reaction system as needed is also often used.

In addition, the layer structure of hydrophilic copolymer particles to be synthesized can also be changed stepwise by devising a method of adding the unsaturated monomer, emulsifier, other additives, and adjuster to the reaction system.

In this case, physical properties representing the structure of each layer include hydrophilicity, glass transition temperature, molecular weight, crosslinking density. The number of layers in this layer structure is not particularly limited.

A known chain transfer agent can be used in the polymerization step of the hydrophilic copolymer (b).

A chain transfer agent containing sulfur can be preferably used as the chain transfer agent. Examples of the chain transfer agent containing sulfur include, but not limited to, an alkanethiol such as t-dodecyl mercaptan and n-dodecyl mercaptan; a thioalkyl alcohol such as mercaptoethanol and mercaptopropanol; a thioalkyl carboxylic acid such as thioglycolic acid and thiopropionic acid; an alkyl thiocarboxylate acid such as octyl thioglycolate and octyl thiopropionate; and a sulfide such as dimethyl sulfide and diethyl sulfide.

Examples of the other chain transfer agents include, but not limited to, terpinolene, dipentene, t-terpinene, and a hydrocarbon halide such as carbon tetrachloride.

Among these chain transfer agents, alkanethiols are preferable because they have large chain transfer rates and give a hydrophilic copolymer (b) having well-balanced physical properties.

These chain transfer agents may be used singly, or two or more thereof may be used in combination.

These chain transfer agents are mixed to monomers and then supplied to a reaction system or independently added in a predetermined amount at a predetermined time. The amount of these chain transfer agents used is preferably 0.1% to 10% by mass based on the total amount of unsaturated monomers used for polymerization of the hydrophilic copolymer (b).

The amount of 0.1% by mass or more provides good processability at the time of mixing the photosensitive resin composition, and the amount of 10% by mass or less enables the molecular weight of the hydrophilic copolymer (b) to be practically sufficient.

A polymerization reaction suppressing agent can be used for polymerization of the hydrophilic copolymer (b) as needed.

The polymerization reaction suppressing agent is a compound added to an emulsion polymerization system to decrease a radical polymerization rate. More specifically, the polymerization reaction suppressing agent includes a polymerization rate retardant, a polymerization inhibitor, a chain transfer agent with low radical reinitiation reactivity, and a monomer with low radical reinitiation reactivity. The polymerization reaction suppressing agent is usually used for adjusting a polymerization reaction rate and adjusting physical properties of a latex. These polymerization reaction suppressing agents are added to a reaction system by batch operation or continuous operation. When the polymerization reaction suppressing agent is used, strength of a latex coating improves in the photosensitive resin composition, and printing durability of the plate thus improves. While details of the reaction mechanism are unclear, the polymerization reaction suppressing agent is thought to closely relate to steric structure of the hydrophilic copolymer (b), and it is considered that the polymerization reaction suppressing agent thus has the effect of adjusting physical properties of a latex coating.

Examples of the polymerization reaction suppressing agent include, but not limited to, quinones such as o-, m-, or p-benzoquinone; nitro compounds such as nitrobenzene, o-, m-, or p-dinitrobenzene; amines such as diphenylamine; catechol derivatives such as tertiary butyl catechol; 1,1-di-substituted vinyl compounds such as 1,1-diphenylethylene or $\alpha$-methylstyrene and 2,4-diphenyl-4-methyl-1-pentene; and 1,2-di-substituted vinyl compounds such as 2,4-diphenyl-4-methyl-2-pentene and cyclohexene. Besides, compounds described as a polymerization inhibitor or polymerization suppressing agent in "POLYMER HANDBOOK 3rd Ed. (J. Brandup, E.H. Immergut: John Wiley & Sons, 1989)," and "Kaitei koubunshigousei no kagaku (Chemistry of polymer synthesis revised edition) (Otsu: Kagaku-Dojin Publishing Company, INC, 1979)" are exemplified.

Among them, 2,4-diphenyl-4-methyl-1-pentene ($\alpha$-methylstyrene dimer) is especially preferable in view of reactivity. These polymerization reaction suppressing agents may be used singly, or two or more thereof may be used in combination.

The amount of these polymerization reaction suppressing agents used is preferably 10% by mass or less based on the total amount of unsaturated monomers used for polymerization of the hydrophilic copolymer (b). By setting the amount to 10% by mass or less, a practically sufficient polymerization rate tends to be obtained.

The radical polymerization initiator, which is a preferable example of the polymerization initiator used for polymerization of the hydrophilic copolymer (b) described above, is radically decomposed under the presence of heat or a reducing substance to initiate addition polymerization of monomers, and any of an inorganic initiator and an organic initiator can be used.

Examples of the radical polymerization initiator include, but not limited to, a water-soluble or oil-soluble peroxodisulfate, a peroxide, and an azobis compound, and specific examples thereof include potassium peroxodisulfate, sodium peroxodisulfate, ammonium peroxodisulfate, hydrogen peroxide, t-butyl hydroperoxide, benzoyl peroxide, 2,2-azobis butyronitrile, and cumene hydroperoxide.

Compounds described in POLYMER HANDBOOK (3rd edition), written by J. Brandup and E.H. Immergut, published by John Willy & Sons, (1989) can also be used as the radical polymerization initiator.

In addition, a so-called redox polymerization method, in which a reducing agent such as sodium acidic sulfite, ascorbic acid or a salt thereof, erythorbic acid and a salt thereof, or Rongalit is used in combination with a polymerization initiator, can also be employed.

Among them, peroxodisulfate is preferable as the polymerization initiator.

The amount of the polymerization initiator used usually falls within a range of 0.1% to 5.0% by mass and is preferably selected from a range of 0.2% to 3.0% by mass based on the total amount of unsaturated monomers used for polymerization of the hydrophilic copolymer (b).

When the amount of the polymerization initiator used is 0.1% by mass or more, high stability can be obtained at the time of synthesizing the hydrophilic copolymer (b), and when the amount of the polymerization initiator used is 5.0% by mass or less, the amount of moisture absorbed by the photosensitive resin composition can be reduced so as to fall within a practically preferable range.

Various polymerization adjusters can be added at the time of synthesizing the hydrophilic copolymer (b) as needed.

A pH adjuster can be added as a polymerization adjuster, and examples of the pH adjuster include, but not limited to, sodium hydroxide, potassium hydroxide, ammonium hydroxide, sodium hydrogen carbonate, sodium carbonate, and disodium hydrogen phosphate.

Various chelating agents such as sodium ethylenediaminetetraacetate, and the like can also be added as a polymerization adjuster.

Furthermore, as other additives, various additives may be added, including a viscosity reducing agent such as an alkali-sensitive latex and hexametaphosphoric acid; a water-soluble polymer such as a polyvinyl alcohol and carboxymethyl cellulose; a thickening agent; various antioxidants; an ultraviolet absorber; an antiseptic agent; a bactericidal agent; a defoaming agent; a dispersant such as sodium polyacrylate; a water resistant agent; a metal oxide such as zinc oxide; a crosslinking agent such as an isocyanate-based compound and an epoxy compound; a lubricant; and a water retaining agent.

A method for adding these additives is not particularly limited, and these additives can be added during synthesis or after synthesis of the hydrophilic copolymer (b).

The polymerization temperature in the case where the hydrophilic copolymer (b) is synthesized through emulsion polymerization is usually selected from a range of 60 to 120°C.

Polymerization may be carried out by the above-described redox polymerization method or the like at a lower temperature. Furthermore, a metal catalyst such as divalent iron ion, trivalent iron ion, and copper ion may be allowed to coexist as a redox catalyst.

The hydrophilic copolymer (b) is preferably particulate, and the average particle diameter thereof is preferably 500 nm or less and more preferably 100 nm or less. When the average particle diameter is 500 nm or less, a printing raw plate to be obtained has good aqueous developing performance.

The toluene gel fraction of the hydrophilic copolymer (b) is preferably 60% to 99%. When the gel fraction is 60% or more, practically sufficient strength tends to be imparted to a printing plate to be obtained.

When the gel fraction is 99% or less, mixing properties between the hydrophilic copolymer (b) and the thermoplastic elastomer (a) tend to be good.

The toluene gel fraction herein is a mass fraction (%) obtained as follows. An appropriate amount of a dispersion containing about 30% by mass of the hydrophilic copolymer (b) is dropped on a Teflon (R) sheet followed by drying at 130°C for 30 minutes; 0.5 g of the hydrophilic copolymer (b) is taken therefrom and immersed in 30 mL of toluene at 25°C followed by shaking for three hours using a shaking device and subsequent filtration with a 320 SUS mesh; the matter not passing through the mesh is dried at 130°C for one hour; and the mass of the dried mater is divided by 0.5 (g).

For development in an aqueous developer, the content of the hydrophilic copolymer (b) in the photosensitive resin composition layer is preferably 10% by mass to 70% by mass based on 100% by mass of the total amount of the photosensitive resin composition in view of developing performance at the time of producing a printing plate. The content of the hydrophilic copolymer (b) is more preferably 15% by mass to 60% by mass and still more preferably 20% by mass to 50% by mass.

<(c) Photopolymerizable monomer>

Examples of the photopolymerizable monomer (c) include, but not limited to, esters of acids such as acrylic acid, methacrylic acid, fumaric acid, and maleic acid; derivatives of acrylamides and methacrylamides; allyl esters, styrene, and derivatives thereof; and N-substituted maleimide compounds.

Examples of the photopolymerizable monomer (c) include, but not limited to, diacrylates and dimethacrylates of alkanediols such as 1,6-hexanediol and 1,9-nonanediol; or diacrylates and dimethacrylates of ethylene glycol, diethylene glycol, propylene glycol, dipropylene glycol, polyethylene glycol, butylene glycol, and dicyclopentadienyl; trimethylolpropane tri(meth)acrylate, dimethyloltricyclodecane di(meth)acrylate, isobornyl (meth)acrylate, phenoxypolyethyleneglycol (meth)acrylate, pentaerythorit tetra(meth)acrylate, N,N'-hexamethylenebisacrylamide and N,N'-hexamethylenebismethacrylamide, styrene, vinyltoluene, divinylbenzene, diacrylphthalate, triallyl cyanurate, diethyl fumarate, dibutyl fumarate, dioctyl fumarate, distearyl fumarate, butyl octyl fumarate, diphenyl fumarate, dibenzyl fumarate, dibutyl maleate, dioctyl maleate, bis(3-phenylpropyl) fumarate, dilauryl fumarate, dibehenyl fumarate, and N-lauryl maleimide.

These may be used singly, or two or more thereof may be used in combination.

It is preferable that the photosensitive resin composition contain, as the photopolymerizable monomer (c), 2.0% by mass or more of a monomer having 2 moles of methacrylate groups per mole of the monomer in view of higher chipping resistance at a convex part of a printing plate.

The content of the photopolymerizable monomer (c) in the photosensitive resin composition layer is preferably 1% by mass to 25% by mass based on 100% by mass of the total amount of the photosensitive resin composition in view of achieving bright printing. The content of the photopolymerizable monomer (c) is more preferably 5% by mass to 20% by mass and still more preferably 8% by mass to 15% by mass.

((d) Photopolymerization initiator)

The photopolymerization initiator (d) is a compound absorbing energy of light and generating a radical. Various known initiators can be used therefor, and various organic carbonyl compounds, especially aromatic carbonyl compounds are preferably used.

Examples of the photopolymerization initiator (d) include, but not limited to, benzophenone, 4,4-bis(diethylamino)benzophenone, t-butyl anthraquinone, 2-ethyl anthraquinone, thioxanthones such as 2,4-diethylthioxanthone, isopropylthioxanthone, and 2,4-dichlorothioxanthone; acetophenones such as diethoxyacetophenone, 2,2-dimethoxy-phenylacetophenone, 2-hydroxy-2-methyl-1-phenylpropane-1-on, benzyl dimethyl ketal, 1-hydroxycyclohexyl-phenyl ketone, 2-methyl-2-morpholino(4-thiomethylphenyl)propane-1-on, and 2-benzyl-2-dimethylamino-1-(4-morpholinophenyl)-butanone; benzoin ethers such as benzoin methyl ether, benzoin ethyl ether, benzoin isopropyl ether, and benzoin isobutyl ether; acylphosphine oxides such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)-phenylphosphine oxide; methyl benzoylformate; and 1,7-bisacridinylheptane; 9-phenylacridine; and 2,6-di-t-butyl-p-cresol.

These may be used singly, or two or more thereof may be used in combination.

The content of the photopolymerization initiator (d) in the photosensitive resin composition layer is preferably 0.1% by mass to 10.0% by mass based on 100% by mass of the total amount of the photosensitive resin composition in view of improving plate formability during plate making and achieving bright printing. The content of the photopolymerization initiator (d) is more preferably 1.0% by mass to 8.0% by mass and still more preferably 1.5% by mass to 5.0% by mass.

A cleavable photopolymerization initiator and a hydrogen-drawing type photopolymerization initiator may be used in combination as the photopolymerization initiator (d). The amount of the hydrogen-drawing type photopolymerization initiator in the photosensitive resin composition is preferably 1.0% by mass or less and more preferably 0.5% by mass or less because image reproducibility of a printing plate and abrasion resistance are high.

(Infrared ablation layer)

The flexographic printing raw plate of the present embodiment has an infrared ablation layer on the photosensitive resin composition layer.

The infrared ablation layer can be subjected to lithography processing using infrared light and serves as a mask image when the photosensitive resin composition layer is exposed and cured. At the time when an unexposed part of the photosensitive resin composition layer is washed out after completion of the exposure, this infrared ablation layer is simultaneously removed.

The infrared ablation layer contains at least an infrared absorber having functions for blocking radial rays of the ultraviolet range to visible light range and absorbing light of the infrared region to convert the light into heat; a dispersant for aiding dispersion of the infrared absorber in the system; and a binder polymer.

Besides, arbitrary components other than the above, such as a filler, silicone oil, a surfactant and a coating aid can be contained without impairing the effects of the present invention.

Regarding the thickness of the infrared ablation layer of the flexographic printing raw plate of the present embodiment, a larger thickness is better in view of ensuring light shielding properties against ultraviolet light in the step of subjecting the flexographic printing raw plate to exposure treatment, and a smaller thickness is better in view of enhancing ablation properties.

In view of the above, the thickness of the infrared ablation layer is preferably 0.1 $\mu$m or more and 20 $\mu$m or less, more preferably 0.5 $\mu$m or more and 15 $\mu$m or less, and still more preferably 1.0 $\mu$m or more and 10 $\mu$m or less.

With respect to a non-infrared light shielding effect of the infrared ablation layer, the optical density of the infrared ablation layer is preferably two or more and more preferably three or more. The optical density can be measured by using D200-II Transmission Densitometer (manufactured by GretagMacbeth). The optical density is so-called visual appreciation (ISO visual), and light to be measured is within a wavelength region of about 400 to 750 nm.

Hereinafter, components contained in the infrared ablation layer will be described in detail.

<Infrared absorber>

The infrared ablation layer of the present embodiment contains an infrared absorber.

A simple substance or compound having strong absorption in a wavelength range of 750 nm to 20000 nm is usually used as the infrared absorber. The infrared absorber preferably serves also as an infrared light shielding substance, but an infrared absorber and an infrared light shielding substance may be individually added.

A substance that has high absorbance in the infrared region and can be uniformly dispersed in the infrared ablation layer is preferable as the infrared absorber. Examples of such a substance include, but not limited to, inorganic pigments such as carbon black, graphite, iron oxide, chromium oxide, and copper chromite; and colorants such as phthalocyanine and a substituted phthalocyanine derivative, a cyanine dye, a merocyanine dye and polymethine dye, and a metal thiolate dye.

A substance reflecting or absorbing ultraviolet light can be used as the infrared light shielding substance. For example, carbon black, an ultraviolet absorber, graphite, and the like are preferable, but the infrared light shielding substance is not limited thereto.

Regarding the infrared absorber and non-infrared light shielding substance, the above-described substances may be used singly, or two or more thereof may be mixed and used.

Carbon black, which has also a non-infrared light shielding effect and is easily available and inexpensive, is especially preferable as the infrared absorber.

The particle diameter of carbon black can be selected from an arbitrary range. However, in general, the smaller the particle diameter is, the higher the sensitiveness to infrared light is; also, the smaller the particle diameter is, the poorer the dispersity is. In view of the above, the particle diameter of carbon black is preferably 20 nm or more and 80 nm or less, more preferably 25 nm or more and 70 nm or less, and still more preferably 30 nm or more and 60 nm or less.

Carbon black is not limited to the following but is classified into furnace black, channel black, thermal black, acetylene black, lamp black, etc., according to its manufacturing method. Furnace black is preferable in view of availability and multiformity.

It is preferable that the content of the infrared absorber in the infrared ablation layer be selected so as to ensure sensitiveness that enables removal by a laser beam used when the infrared ablation layer is subjected to lithography processing.

Sensitiveness to the laser beam is higher as the amount of the infrared absorber uniformly dispersed in the infrared ablation layer increases; however, when the amount of the infrared absorber is excessively large to cause aggregation and the like, sensitiveness tends to decrease on the contrary. In view of this, the content of the infrared absorber is preferably 10% by mass or more and 90% by mass or less, more preferably 20% by mass or more and 80% by mass or less, and still more preferably 30% by mass or more and 70% by mass or less, based on the whole infrared ablation layer.

A method for forming the infrared ablation layer using carbon black as the infrared absorber will be described by giving an example.

The following method is effective, for example: a binder polymer solution is prepared using an appropriate solvent, carbon black and a dispersant are added thereto, the carbon black is dispersed in the binder polymer solution, the resultant is applied to a cover film such as a polyester film, and the resulting cover film is subsequently laminated on or press-bonded to the photosensitive resin composition layer to transfer the non-infrared light shielding layer capable of being ablated by an infrared laser.

A method in which forced stirring using a stirring blade and stirring utilizing ultrasonic waves or various mills are combined is effective as a method for dispersing carbon black in a binder polymer solution. Alternatively, a method in which a binder polymer, carbon black, and a dispersant are prekneaded using an extruder or kneader and subsequently dissolved in a solvent is also beneficial to obtain good dispersibility of carbon black. Carbon black may be forcibly dispersed in a polymer in a latex solution state.

The infrared absorber preferably has a surface functional group capable of interacting with an adsorbing moiety of the dispersant described later. Examples of such a surface functional group include, but not limited to, a carbonyl group, a carboxy group, an aldehyde group, a hydroxy group, phenyl group, a sulfone group, a nitro group, maleic anhydride, a quinone, a lactone, and an ester.

For a simple method for evaluating the surface functional group content in the infrared absorber, pH values obtained by the measurement method defined in ASTM D1512 are used.

The pH value is preferably 9 or less, more preferably 8.5 or less, and still more preferably 8 or less in view of obtaining sufficient interaction with the dispersant.

Meanwhile, the pH value is preferably 2.5 or more, more preferably 3.0 or more, and still more preferably 3.5 or more in view of suppressing interaction between the infrared ablation layer and the cover film and facilitating peeling.

<Dispersant>

The dispersant contained in the infrared ablation layer is a compound having an adsorbing moiety capable of interacting with the surface functional group of the infrared absorber and a resin compatible moiety capable of being compatible with the binder polymer.

Examples of the adsorbing moiety of the dispersant include, but not limited to, an amino group, an amide group, a urethane group, a carboxyl group, a carbonyl group, a sulfone group, and a nitro group, and an amino group, an amide group, and a urethane group are preferable.

Examples of the resin compatible moiety include, but not limited to, a saturated alkyl, an unsaturated alkyl, a polyether, a polyester, a poly(meth)acryl, and a polyol.

The base number of the dispersant is 5 to 100 mgKOH/g.

The base number can be measured according to the potentiometric titration method (base number-perchloric acid method) defined in JIS K 2501 (2003).

Specifically, the amount of perchloric acid required to neutralize basic components included in 1 g of a sample is measured, and the base number can be represented by the number of milligrams of potassium hydroxide (KOH) equivalent to the amount of perchloric acid.

A commercially available dispersant can be used. When the dispersant is a commercial product, the base number of catalog data thereof is preferentially adopted.

In the infrared ablation layer, the base number of the dispersant is required to be 5 mgKOH/g or more in order to prevent adhesion between the infrared ablation layer and the cover film and enable the cover film to be peeled without any practical problem.

Adhesion between the infrared ablation layer and the cover film is caused by intermolecular force between the contained components of the infrared ablation layer and the cover film. Especially, carbon black in the infrared ablation layer has a polar functional group on its surface and therefore largely contributes to adhesion.

Then, the interaction with the cover film can be prevented by adsorbing the dispersant onto the surface of the carbon black to cover it, and adhesion can be consequently suppressed.

When the base number of the dispersant is 5 mgKOH/g or more, interaction with carbon black becomes sufficiently strong, and interaction with the cover film can be sufficiently prevented.

On the other hand, it is also required that the base number of the dispersant is 100 mgKOH/g or less.

When the base number of the dispersant is 100 mgKOH/g or less, interaction between the basic part of the dispersant and the cover film can be prevented from excessively increasing, and adhesion can be efficiently suppressed.

In view of the above, the base number of the dispersant is required to be 5 mgKOH/g or more and is preferably 10 mgKOH/g or more and more preferably 20 mgKOH/g or more. In addition, the base number of the dispersant is also required to be 100 mgKOH/g or less and is preferably 50 mgKOH/g or less and more preferably 35 mgKOH/g or less.

The base number of the dispersant can be controlled to fall within the above-described numerical ranges by the content of basic groups in the dispersant.

Examples of the basic groups include, but not limited to, a nitrogen-containing functional group having an amino group, an amide group, a pyridyl group, and a urethane bond.

In the infrared ablation layer, the absolute value of the difference between solubility parameters (SP values) of the dispersant and the binder polymer described layer is preferably 0.3 $(cal/cm^3)^{1/2}$ or more. When said value is 0.3 $(cal/cm^3)^{1/2}$ or more, compatibility between the dispersant and the binder polymer decreases, and the dispersant is concentrated on the surface of carbon black; consequently, the intended effects of the dispersant can be provided.

It is also preferable that the absolute value of the difference between solubility parameters (SP values) of the dispersant and the binder polymer be 4.0 $(cal/cm^3)^{1/2}$ or less. When said value is 4.0 $(cal/cm^3)^{1/2}$ or less, compatibility between the dispersant and the binder polymer can be ensured to disperse carbon black, and generation of a PH (pin hole) in the infrared ablation layer can be prevented.

In view of the above, the absolute value of the difference between solubility parameters (SP values) of the dispersant and the binder polymer is preferably 0.3 $(cal/cm^3)^{1/2}$ or more and 4.0 $(cal/cm^3)^{1/2}$ or less. Regarding the lower limit, it is more preferably 1.0 $(cal/cm^3)^{1/2}$ or more and still more preferably 1.5 $(cal/cm^3)^{1/2}$ or more in view of the above.

Regarding the upper limit, it is more preferably 3.0 $(cal/cm^3)^{1/2}$ or less and still more preferably 2.5 $(cal/cm^3)^{1/2}$ or less in view of the above.

As described later, the binder polymers may be used in combinations of two or more. In such a case, the absolute value of the difference between SP values between the dispersant and the principal binder polymer, the mass of which is largest, may be adopted.

The solubility parameter SP value $\delta$ in the invention of the present application is defined by formula (1) below:

$$\delta \ = \ (\Delta E/V)^{1/2}[\,(cal/cm^3)^{1/2}] \ \cdots \ (1)$$

wherein, V is the molar volume of a solvent, and $\Delta E$ is aggregation energy (evaporation energy) of the solvent.

The molar volume and aggregation energy of the solvent can also be obtained from known values as in the document "POLYMER ENGINEERING AND SCIENCE, vol. 14, 147-154, 1974," for example.

On the other hand, when the above parameters are not known, the above parameters can also be actually measured using a technique called a turbidimetric titration method.

Specifically, into a solution of a sample with an unknown SP value in a good solvent with a known SP value, a poor solvent with an SP value lower than that of the good solvent is dropped, and the volume of the poor solvent at which a solute started to precipitate is measured firstly. Subsequently, into a newly prepared solution of a sample with an unknown SP value in a good solvent with a known SP value, a poor solvent with an SP value higher than that of the good solvent is dropped, and the volume of the poor solvent at which a solute started to precipitate is measured. The SP value can be obtained by applying the volumes of the poor solvents measured here to formula (2) below:

$$\delta \ = \ (V_{ml}^{1/2}{\cdot}\delta_{ml} \ + \ V_{mh}^{1/2}{\cdot}\delta_{mh})/(V_{ml}^{1/2} \ + \ V_{mh}^{1/2}) \ \cdots \ (2)$$

wherein, $V_{ml}$ is the volume of the poor solvent with a lower SP value, $V_{mh}$ is the volume of the poor solvent with a higher SP value, $\delta_{ml}$ is the SP value of the poor solvent with a lower SP value, and $\delta_{mh}$ is the SP value of the poor solvent with a higher SP value.

Values actually measured by the turbidimetric titration method described above are used for all of the SP values described in Examples described later.

It is preferable that the content of the dispersant in the infrared ablation layer of the present embodiment be selected so as to ensure the strength of the infrared ablation layer while uniformly dispersing the infrared absorber in the infrared ablation layer.

When the content of the dispersant is small, the infrared absorber cannot be sufficiently dispersed in the infrared ablation layer. The content of the dispersant is too much, strength of the film decreases, which may cause multiple generation of PHs (pin holes).

In view of this, the content of the dispersant based on the whole infrared ablation layer of the present embodiment is preferably 0.1% by mass or more and 50% by mass or less, more preferably 1% by mass or more and 30% by mass or less, and still more preferably 3% by mass or more and 20% by mass or less.

In relation to the infrared absorber, the content of the dispersant is preferably 0.5 parts by mass or more, more preferably 1 part by mass or more, and still more preferably 3 parts by mass or more per 100 parts by mass of the infrared absorber in view of dispersity of the infrared absorber. The content of the dispersant is preferably 50 parts by mass or less, more preferably 30 parts by mass or less, and still more preferably 20 parts by mass or less in view of film strength of the infrared ablation layer.

In the flexographic printing raw plate of the present embodiment, the dispersant in the infrared ablation layer preferably has a branched structure. When the dispersant has a branched structure, crystallinity of the dispersant is low, and therefore, high dispersity is provided.

The weight average molecular weight of the dispersant in the infrared ablation layer of the present embodiment is preferably selected so as not to cause bleedout of the dispersant while uniformly dispersing the infrared absorber in the infrared ablation layer.

When bleedout of the dispersant occurs, the dispersant cannot interact with the infrared absorber, for example, with carbon black, which results in causing insufficient dispersion, causing peeling to get heavy, and causing aggregation of the infrared absorber, for example, of carbon black to generate a pin hole (PH).

In view of this, the weight average molecular weight of the dispersant measured by gel permeation column chromatography (GPC) in terms of standard polystyrene is preferably 1000 or more and 10000 or less, more preferably 2000 or more and 7000 or less, and still more preferably 2500 or more and 5000 or less.

<Binder polymer>

The infrared ablation layer contains a binder polymer.

Examples of the binder polymer include, but not limited to, acrylic resin, styrene-based resin, vinyl chloride-based resin, vinylidene chloride-based resin, polyolefin-based resin, polyamide-based resin, polyacetal-based resin, polybutadiene-based resin, polycarbonate-based resin, polyester-based resin, polyphenylenesulfide-based resin, polysulfone-based resin, polyetherketone-based resin, polyimide-based resin, fluororesin, silicone-based resin, urethane-based resin, urea-based resin, melamine-based resin, guanamine-based resin, epoxy-based resin, phenolic resin, and copolymers of these resin. In the binder polymer, the portion of the above-listed compounds is preferably 80% by mass or more and more preferably 90% by mass or more, and may be 100% by mass.

The binder polymer described above may include various functional groups such as an amino group, a nitro group, a sulfonic acid group, a phosphoric acid group, a carboxylic acid group, and a halogen as long as they do not impair compatibility between the infrared absorber, for example, carbon black and the dispersant.

The binder polymers described above may be used singly, or in combinations of two or more thereof.

When the binder polymers are used in combinations of two or more thereof, the binder polymers may be selected according to performance required.

For example, in view of scratch resistance, a thermoplastic elastomer including a copolymer of a monovinyl-substituted aromatic hydrocarbon monomer and a conjugated diene monomer, a hydrogenated product of said copolymer, polyamide-based resin, polyvinyl alcohol-based resin are preferable, a thermoplastic elastomer including a copolymer of a monovinyl-substituted aromatic hydrocarbon monomer and a conjugated diene monomer and a hydrogenated product of said copolymer are more preferable.

In addition, since adhesion between the infrared ablation layer and the cover film is caused by intermolecular force between the contained components of the infrared ablation layer and the contained components of the cover film, a binder polymer with fewer polar groups is preferably used in view of peelability. For example, a thermoplastic elastomer including a copolymer of a monovinyl-substituted aromatic hydrocarbon monomer and a conjugated diene monomer, a hydrogenated product of said copolymer, and a poly(meth)acrylate are preferably used.

In a case where water developability is required, polyamide, polybutyral, polyvinyl alcohol, poly(meth)acrylate, and a modified product or partially saponified product thereof are preferably used.

The number average molecular weight of the binder polymer can be arbitrary and may be selected in consideration of desired PH (pin hole) resistance and ablation efficiency of the infrared ablation layer.

In general, the smaller the number average molecular weight, the softer; also, the smaller the number average molecular weight, the lower the scratch resistance. The larger the number average molecular weight is, the lower the ablation efficiency is, on the contrary.

The number average molecular weight of the binder polymer is preferably 1000 or more and still more preferably 3000 or more in view of PH resistance of the infrared ablation layer.

The number average molecular weight is preferably 200000 or less and more preferably 150000 or less in view of ablation efficiency.

The upper and lower limits of these numerical values are arbitrary combined.

The number average molecular weight of the binder polymer can be controlled to fall within the above numerical ranges by appropriately adjusting polymerization conditions of the polymer, for example, polymerization conditions such as a monomer amount, polymerization time, and polymerization temperature.

Mixing a plurality of polymers is also effective to obtain a desired number average molecular weight.

The content of the binder polymer in the whole infrared ablation layer can be arbitrary as long as it does not impair the purpose of the present invention.

The content of the binder polymer is preferably 20% by mass or more, more preferably 30% by mass or more, and still more preferably 40% by mass or more, based on the whole infrared ablation layer, in view of PH resistance.

The content is preferably 90% by mass or less, more preferably 70% by mass or less, and still more preferably 60% by mass or less in view of increasing the concentration of the infrared absorber such as carbon black for improving sensitiveness to infrared light. The upper and lower limits of these numerical values are arbitrary combined.

<Additives>

The infrared ablation layer is formed on a cover film as described later, and is generally formed through application of a solution or dispersion at the time of film formation to a cover film followed by drying.

In order to improve wettability of the solution or dispersant to the cover film and film uniformity, silicone resin, a surfactant, and other additives desired may be added.

Commonly used nonionic, cationic, anionic, and ampholytic surfactants are applicable as the surfactant, and the surfactant may be appropriately selected.

Examples of the silicone resin include, but not limited to, unmodified silicone oil such as dimethyl silicone oil and methyl phenyl silicone oil; and modified silicone oil such as polyether-modified silicone, aralkyl-modified silicone, fluoroalkyl-modified silicone, and long chain alkyl-modified silicone.

Examples of a fluorine-based surfactant include, but not limited to, a perfluoroalkyl group-containing acid salt, a perfluoroalkyl group-containing ester, and an oligomer containing a fluorine-containing group.

Taking gas generated during ablation into consideration, silicone resin is more preferable among them for environment, and polyether-modified silicone is especially preferable in view of the balance between peelability and application stability of a coating liquid for preparing the ablation layer.

The content of the surfactant and additives in the infrared ablation layer can be arbitrarily set as long as they do not impair the effects of the present invention.

Regarding the range desirably exhibiting the effects of these surfactant and additives, the content is preferably 0.1% by mass or more and 30% by mass or less, more preferably 0.5% by mass or more and 25% by mass or less, and still more preferably 1.0% by mass or more and 20% by mass or less.

These surfactant and additives may be water-soluble or water-insoluble as long as they do not significantly increase hygroscopic properties of the infrared ablation layer; however, they are more preferably water-insoluble in view of hygroscopic properties.

<Coating solvent>

The solvent for a solution and dispersant for forming a film of the infrared ablation layer can be appropriately selected taking solubility of the polymer used and solubility of the infrared absorber used.

Only one solvent may be used, or two or more solvents may be mixed and used.

In addition, it is also effective that a solvent having a relatively low boiling point and a solvent having a high boiling point be mixed to control the volatilization rate of the solvent to thereby improve the film quality of the infrared ablation layer, for example.

Examples of the solvent for forming a film of the infrared ablation layer include, but not limited to, toluene, xylene, cyclohexane, methyl acetate, ethyl acetate, propyl acetate, butyl acetate, amyl acetate, methyl ethyl ketone, acetone, cyclohexanone, ethylene glycol, propylene glycol, ethanol, water, propylene glycol monomethyl ether, propylene glycol monomethyl ether acetate, dimethylacetamide, dimethylformamide, n-propyl alcohol, i-propyl alcohol, 1,4-dioxane, tetrahydrofuran, diethylether, n-hexane, n-heptane, n-pentane, acetonitrile, and an analogue thereof.

(Cover film)

The cover film for forming a film of the infrared ablation layer of the present embodiment is preferably a film excellent in dimensional stability, and a polyethylene terephthalate film and the like is preferable, for example.

The cover film may be used without treatment. However, a cover film to which functions are imparted through release treatment, antistatic treatment, etc. is imparted may be used as needed.

(Intermediate layer)

The flexographic printing raw plate of the present embodiment may further have one or more intermediate layers between the photosensitive resin composition layer and the infrared ablation layer.

In order to produce a printed matter having high definition and a highlight area, a micro dot which has a flat part of a dot tip with a diameter of 10 to 20 $\mu$m and also has a relief depth of 100 $\mu$m or more is required to be formed. The intermediate layer is preferably an oxygen inhibiting layer having oxygen inhibiting ability so as to achieve such a micro dot.

In addition, the intermediate layer may be an adhesive layer having adhesive ability.

When the photosensitive resin composition layer is cured by ultraviolet irradiation, curing is progressed through radical polymerization. When oxygen coexists at the time of polymerization, a radical-generating compound reacts with oxygen to suppress polymerization reaction. When an unreacted portion remains in the photosensitive resin composition layer due to suppression of polymerization reaction, the shape of a pattern finally formed has a curved portion at the tip thereof. On the other hand, when the amount of oxygen coexisting is decreased at the time of ultraviolet curing, polymerization reaction is unlikely to be suppressed, and the shape of a pattern finally formed has a flat part at the tip thereof. Accordingly, for preparing a pattern having a flat part at the tip thereof, it is effective to decrease oxygen contacting the photosensitive resin composition layer by imparting oxygen inhibiting ability to the intermediate layer.

The intermediate layer also has a function for protecting the infrared ablation layer.

In the manufacturing process of a conventional flexographic printing raw plate, the infrared ablation layer comes into contact with a roll at the time of feeding a film of the infrared ablation layer, or the infrared ablation layer and a protective film rub against each other due to winding constriction occurring during transportation of a film roll. These may cause brakeage of the infrared ablation layer physically, which may generate a pin hole.

The photosensitive resin composition layer and the infrared ablation layer may be stacked by a method in which the infrared ablation layer is coated with the photosensitive resin composition layer while extruding the photosensitive resin composition layer, and in such a case, a pin hole may be generated due to friction caused when the heated and melted photosensitive resin composition flows on the infrared ablation layer.

In order to prevent such generation of a pin hole in the infrared ablation layer, the intermediate layer included in the flexographic printing raw plate of the present embodiment has physical strength and heat resistance.

As described above, in order to produce a printed matter having high definition and a highlight area, a micro dot in which a flat part of the dot tip has a diameter of 10 to 20 $\mu$m is required to be formed; therefore, if a mask image for forming micro dots overlaps the periphery of a pin hole of 20 $\mu$m or more in the infrared ablation layer, dot formation failure may occur to result in failure in production of a flexographic printing plate having high definition and a highlight area.

Furthermore, it is preferable that the intermediate layer can be cleaned with the same cleaning liquid as that for the infrared ablation layer and/or the photosensitive resin composition layer, in view of simplicity of manufacturing process of a flexographic printing plate.

When the intermediate layer has high cleanability, time required for a cleaning step can be shortened to improve workability, and the photosensitive resin composition layer located below the intermediate layer can be easily developed.

Examples of the material preferably used for the intermediate layer include, but not limited to, polymers such as an ethylene-vinyl alcohol copolymer, a polyvinyl alcohol, a polyvinyl acetate, a polyvinyl butyral, a polyvinylpyrrolidone, a polyvinyl chloride, a polyvinylidene chloride, a polyvinyl fluoride, a polyvinylidene fluoride, a polyacrylonitrile, polymethyl methacrylate, a polyacetal, a polycarbonate, a polystyrene, a polycarbonate, a polyethylene, a polypropylene, a cellulose derivative, a polyester, a polyamide, a polyimide, a polyurethane, silicone rubber, butyl rubber, and isoprene rubber.

These polymers may be used singly, or two or more thereof may be used in combination.

In addition, other ingredients, for example, a surfactant, a blocking preventing agent, a release agent, a UV absorber, a dye, and a pigment may be added to the intermediate layer.

The thickness of the intermediate layer is preferably 0.5 $\mu$m or more and 20 $\mu$m or less. When the thickness is 0.5 $\mu$m or more, sufficient film strength is provided, and when the thickness is 20 $\mu$m or less, sufficient cleanability can be provided. The thickness of the intermediate layer is more preferably 0.5 $\mu$m or more and 10 $\mu$m or less and still more preferably 0.5 $\mu$m or more and 5 $\mu$m or less.

Examples of the material used for the intermediate layer also includes a water-dispersion latex as preferable material. Examples of the water-dispersion latex include, but not limited to, water-dispersible latex polymers such as polybutadiene latex, natural rubber latex, styrene-butadiene copolymer latex, acrylonitrile-butadiene copolymer latex, polyvinylidene chloride latex, polychloroprene latex, polyisoprene latex, polyurethane latex, methacrylate methyl-butadiene copolymer latex, vinylpyridine polymer latex, butyl polymer latex, Thiokol polymer latex, and acrylate polymer latex; and a copolymer obtained by copolymerizing any of these polymers with another component such as acrylic acid or methacrylic acid.

Among them, a water-dispersion latex copolymer containing a butadiene skeleton or an isoprene skeleton in a molecular chain is preferable in view of hardness and rubber elasticity. Specifically, polybutadiene latex, styrene-butadiene copolymer latex, acrylonitrile-butadiene copolymer latex, methacrylate methyl-butadiene copolymer latex, and polyisoprene latex are preferable.

The water-dispersion latex contained in the intermediate layer included in the flexographic printing raw plate of the present embodiment has a polar group, and preferable examples of the polar group include a carboxy group, an amino group, a hydroxy group, a phosphoric acid group, a sulfonic acid group, and a salt thereof.

In view of obtaining high cleanability and excellent adhesion between layers in a flexographic printing plate using the flexographic printing raw plate of the present embodiment, latex having a carboxy group or hydroxy group is preferable as the water-dispersion latex.

These water-dispersion latexes having a polar group may be used singly or in combinations of two or more thereof.

The water-dispersion latex having a carboxyl group includes latex containing an unsaturated monomer having a carboxyl group as a polymerization monomer, and examples of the unsaturated monomer having a carboxyl group include a monobasic acid monomer and a dibasic acid monomer.

Examples of the monobasic acid monomer include acrylic acid, methacrylic acid, crotonic acid, vinylbenzoic acid, and cinnamic acid; and a sodium salt, a potassium salt, an ammonium salt, and the like of these monobasic acid monomers.

Examples of the dibasic acid monomer include itaconic acid, fumaric acid, maleic acid, citraconic acid, and muconic acid; and a sodium salt, a potassium salt, an ammonium salt, and the like of these dibasic acid monomers.

In the present embodiment, the unsaturated monomers having a carboxyl group may be used singly, or multiple kinds of the unsaturated monomer having a carboxyl group may be used at the same time.

The water-dispersion latex having a hydroxy group includes latex containing an ethylene-based monocarboxylic acid alkyl ester monomer as a polymerization monomer. Examples of the ethylene-based monocarboxylic acid alkyl ester monomer include, but not limited to, 2-hydroxyethyl acrylate, 2-hydroxyethyl methacrylate, 2-hydroxypropyl acrylate, 2-hydroxypropyl methacrylate, 1-hydroxypropyl acrylate, 1-hydroxypropyl methacrylate, and hydroxycyclohexyl (meth)acrylate.

The content of the water-dispersion latex in the intermediate layer is preferably 3% by mass or more, more preferably 10% by mass or more, and still more preferably 20% by mass or more, based on the total amount of the intermediate layer, in view of resin adhesion.

In addition, in view of suppressing stickiness, the content is preferably 90% by mass or less, more preferably 80% by mass or less, and still more preferably 70% by mass or less.

When the content of the water-dispersion latex in the intermediate layer is 3% by mass or more, sufficient adhesion is provided, and when the content is 90% by mass or less, a flexographic printing raw plate having sufficient film strength and less tackiness is obtained.

The toluene gel fraction of the water-dispersion latex is preferably 70% by mass or more and 90% by mass or less. The toluene gel fraction is more preferably 70% by mass or more and 85% by mass or less and still more preferably 70% by mass or more and 80% by mass or less.

When the toluene gel fraction of the water-dispersion latex falls within the range of 70% by mass or more and 90% by mass or less, a flexographic printing raw plate with less stickiness is obtained while maintaining sufficient rubber elasticity and film strength.

The toluene gel fraction of the water-dispersion latex herein can be measured by the following method.

A dispersion of the water-dispersion latex after emulsion polymerization is dried at 130°C for 30 minutes to obtain a coating; 0.5 g of the coating is taken and immersed in 30 mL of toluene at 25°C followed by shaking for three hours using a shaking device and subsequent filtration with a 320 SUS mesh; the matter not passing through the mesh is dried at 130°C for one hour; and the mass X (g) of the dried mater is measured.

The gel fraction is calculated by the following equation.

$$\texttt{Gel fraction (mass\%) = X (g)/0.5 (g)} \times 100$$

The toluene gel fraction of the water-dispersion latex can be controlled to fall within the above-described numerical range by adjusting the polymerization temperature, monomer composition, amount of the chain transfer agent, and particle diameter.

A water-soluble polyurethane contained in the intermediate layer is not particularly limited as long as it is a polymer having a urethane bond, and examples thereof include a polyurethane obtained by reacting a polyol compound and a polyisocyanate.

In view of stably dissolving or dispersing the water-soluble polyurethane in an organic solvent and/or water, it is also preferable that a hydrophilic group-containing compound be added as a polymerization component in addition to the polyol compound and polyisocyanate.

Examples of the polyol compound include, but not limited to, a polyether polyol, a polyester polyol, a polycarbonate diol, and a polyacrylic polyol.

These may be used singly, or two or more thereof may be used in combination.

Among them, a polyether polyol is preferable in view of adhesion.

Examples of the polyether polyol include a polyether polyol obtained by subjecting a polyhydric alcohol to ring-opening polymerization with an ionically polymerizable cyclic compound, that is, a reaction product of a polyhydric alcohol and an ionically polymerizable cyclic compound.

Examples of the polyhydric alcohol include, but not limited to, ethylene glycol, polyethylene glycol, propylene glycol, polypropylene glycol, polytetramethylene glycol, polyhexamethylene glycol, polyheptamethylene glycol, polydecamethylene glycol, glycerol, trimethylolpropane, pentaerythritol, bisphenol A, bisphenol F, hydrogenated bisphenol A, hydrogenated bisphenol F, hydroquinone, naphthohydroquinone, anthrahydroquinone, 1,4-cyclohexanediol, tricyclodecanediol, tricyclodecanedimethanol, pentacyclopentadecanediol, and pentacyclopentadecanedimethanol.

These may be used singly, or two or more thereof may be used in combination.

Examples of the ionically polymerizable cyclic compound include, but not limited to, cyclic ethers such as ethylene oxide, propylene oxide, 1,2-butylene oxide, 1-butene oxide, isobutene oxide, 3,3-bis(chloromethyl)oxetane, tetrahydrofuran, 2-methyltetrahydrofuran, 3-methyltetrahydrofuran, dioxane, trioxane, tetraoxane, cyclohexene oxide, styrene oxide, epichlorohydrin, glycidyl methacrylate, allyl glycidyl ether, allyl glycidyl carbonate, butadiene monoxide, isoprene monoxide, vinyloxetane, vinyltetrahydrofuran, vinylcyclohexeneoxide, phenyl glycidyl ether, butyl glycidyl ether, and benzoic acid glycidyl ester.

These may be used singly, or two or more thereof may be used in combination.

As the polyol compound, a polyether polyol obtained by subjecting the ionically polymerizable cyclic compound to ring-opening polymerization with a cyclic imine such as ethyleneimine, β-propiolactone, a cyclic lactonic acid such as lactide glycolate, or a dimethylcyclopolysiloxane can also be used.

These ring-opened copolymers of the ionically polymerizable cyclic compound may be random copolymers or bock copolymers.

Polyisocyanates generally used for producing polyurethanes can be used as the polyisocyanate without limitation.

Examples of the polyisocyanate include, but not limited to, 2,4-tolylene diisocyanate, 2,6-tolylene diisocyanate, 1,3-xylylene diisocyanate, 1,4-xylylene diisocyanate, 1,5-naphthalene diisocyanate, m-phenylene diisocyanate, p-phenylene diisocyanate, 3,3'-dimethyl-4,4'-diphenylmethane diisocyanate, 4,4'-diphenylmethane diisocyanate, 3,3'-dimethylphenylene diisocyanate, 4,4'-biphenylene diisocyanate, 1,6-hexane diisocyanate, isophorone diisocyanate, methylenebis(4-cyclohexyl isocyanate), 2,2,4-trimethylhexamethylene diisocyanate, bis(2-isocyanatoethyl)fumarate, 6-isopropyl-1,3-phenyl diisocyanate, 4-diphenylpropane diisocyanate, lysine diisocyanate, hydrogenated diphenylmethane diisocyanate, hydrogenated xylylene diisocyanate, tetramethylxylylene diisocyanate, and 2,5(or 6)-bis(isocyanatemethyl)-bicyclo[2.2.1]heptane.

These polyisocyanates may be used singly, or two or more thereof may be used in combination.

Regarding the water-soluble polyurethane contained in the intermediate layer, a film made of the water-soluble polyurethane has elongation of preferably 300% or more and more preferably 600% or more, in view of enhancing PH (pin hole) resistance of the infrared ablation layer included in the flexographic printing raw plate and maintain flexibility of the flexographic printing raw plate when hot extrusion molding is carried out in the manufacturing process of the flexographic printing raw plate of the present embodiment.

The heat softening temperature of the water-soluble polyurethane is preferably 80°C to 210°C. The heat softening temperature is preferably 80°C or more in view of PH (pin hole) resistance and is preferably 210°C or less in view of adhesion.

The heat softening temperature is more preferably 110°C to 180°C and still more preferably 120°C to 170°C.

The heat softening temperature of the water-soluble polyurethane can be measured with a Koka-type flow tester.

The heat softening temperature of the water-soluble polyurethane can be controlled to fall within the above-described numerical range by adjusting the types and combinations of the diol component and diisocyanate component included in the water-soluble polyurethane.

Three parameters, specifically, the heat melting temperature, elongation, and breaking strength, of a film made of the water-soluble polyurethane alone contained in the intermediate layer are properties affecting PH resistance of the infrared ablation layer.

The temperature of resin (material for photosensitive resin composition layer) after kneading is about 120°C to 140°C in manufacturing the flexographic printing raw plate of the present embodiment. At that time, as the heat softening temperature of the film made of the water-soluble polyurethane alone contained in the intermediate layer is close to or lower than the resin temperature after kneading, and as the elongation of the film made of the water-soluble polyurethane alone increases, the water-soluble polyurethane follows the shear stress of the resin after kneading, which makes it easier to form the infrared ablation layer and the intermediate layer into a sheet.

In addition, the intermediate layer directly contacting kneaded resin breaks due to scratch by a gelatinous matter when heat-laminating kneaded resin (also containing a gelatinous matter due to insufficient kneading), which is material included in the photosensitive resin composition layer, the infrared ablation layer, and the intermediate layer, and a pin hole is thus generated in the infrared ablation layer; accordingly, the film made of the water-soluble polyurethane alone preferably has greater breaking stress.

The number average molecular weight of the water-soluble polyurethane is preferably 1,000 to 200,000 and more preferably 30,000 to 100,000, in view of flexibility of the intermediate layer.

The water-soluble polyurethane contained in the intermediate layer is preferably a polyether polyurethane obtained by reacting a polyether polyol with an isocyanate in view of adhesion with the infrared ablation layer or photosensitive resin composition layer. As such a polyether polyurethane, commercially available products including SUPERFLEX 300 (manufactured by DKS Co., Ltd.) and HYDRAN WLS202 (manufactured by DIC Corporation) may be used, for example.

The water-soluble polyurethane preferably has any structure of a polyether, a polyester, a polycarbonate, and a polyester-ether within its molecule, with a polyether, a polyester, and a polycarbonate being further preferable. Furthermore, the water-soluble polyurethane preferably has a polyether structure in view of adhesion.

Resin adhesive force, that is, adhesive force between the intermediate layer and the photosensitive resin composition layer is developed by the water-dispersion latex and water-soluble polyurethane contained in the intermediate layer.

With respect to initial adhesion, the water-soluble polyurethane mainly contributes to the resin adhesive force, and a water-soluble polyurethane with a lower Tg tends to provide excellent resin adhesive force since the photosensitive resin composition layer is more wettable thereto.

The anchor effect of the water-dispersion latex contributes to adhesive force after the flexographic printing raw plate has been left for a long period.

When a styrene butadiene-based resin is used in the photosensitive resin composition layer, the styrene butadiene-based resin tends to be compatible with the water-dispersion latex in the intermediate layer; accordingly, the anchor effect is developed by migration during long-term storage, and resin adhesive force is maintained even after long-term storage.

The content of the water-soluble polyurethane in the intermediate layer is preferably 10% by mass or more, more preferably 20% by mass or more, and still more preferably 40% by mass or more, based on the total amount of the intermediate layer.

The content is preferably 90% by mass or less, more preferably 80% by mass or less, and still more preferably 70% by mass or less.

When the content of the water-soluble polyurethane is 10% by mass or more based on the total amount of the intermediate layer, sufficient PH (pin hole) resistance is provided, and when the content is 90% by mass or less, sufficient adhesion is provided.

The water-soluble polyurethane preferably has a polar group in view of cleanability and strength of the intermediate layer at a high temperature.

Examples of the polar group include, but not limited to, a hydroxy group, an alkoxy group, a polyether group such as an ethylene oxide group, and a propylene oxide group; a carbonyl group, a carboxyl group, an amino group, a urea group, a cyano group, a sulfonic acid group, and a phosphoric acid group.

Among them, a water-soluble polyurethane having a carboxyl group or hydroxy group is preferable.

The intermediate layer may further include a water-soluble polyamide.

The water-soluble polyamide is not particularly limited as long as it is a polymer having a polyamide bond and includes a lactam, an amino carboxylic acid, an equimolar salt of a diamine and a dicarboxylic acid, and the like having 4 to 40 carbon atoms.

Conventionally known soluble synthetic polymer compounds can be used as the polymer having the polyamide bond. Examples thereof include a polyether amide (for example, see Japanese Patent Laid-Open No. 55-79437), a polyether-ester amide (for example, see Japanese Patent Laid-Open No. 58-113537), a tertiary nitrogen-containing polyamide (for example, see Japanese Patent Laid-Open No. 50-76055), an ammonium salt-type tertiary nitrogen-containing polyamide (for example, see Japanese Patent Laid-Open No. 53-36555), an addition polymerization product of an amide compound having one or more amide bonds and an organic diisocyanate compound (for example, see Japanese Patent Laid-Open No. 58-140737), and an addition polymerization product of a diamine having no amide bond and an organic diisocyanate compound (for example, see Japanese Patent Laid-Open No. 4-97154).

These water-soluble polyamides may be used singly, or two or more thereof may be used in combination.

Especially, a tertiary nitrogen-containing polyamide and ammonium salt-type tertiary nitrogen-containing polyamide capable of imparting appropriate hardness to the intermediate layer are preferably used.

The content of the water-soluble polyamide in the intermediate layer is 10 to 700 parts by mass, preferably 15 to 600 parts by mass, and more preferably 20 to 500 parts by mass, per 100 parts by mass of the water-dispersion latex.

When the content of the water-soluble polyamide is 10 parts by mass or more per 100 parts by mass of the water-dispersion latex, film strength of the intermediate layer can be maintained, and sufficient PH resistance is consequently provided.

When the content of the water-soluble polyamide is 700 parts by mass or less, resin adhesion can be maintained.

[Manufacturing method of stack for forming infrared ablation layer]

The stack for forming an infrared ablation layer for forming the infrared ablation layer for the flexographic printing raw plate of the present embodiment can be manufactured as follows.

First, a coating liquid containing components for the infrared ablation layer and a solvent is prepared.

Next, the cover film is coated with the coating liquid to form a coating layer (coating step).

The solvent is then removed from the coating layer (drying step).

When the above-described intermediate layer is formed, the intermediate layer is formed on the infrared ablation layer side through the coating step and the drying step as for forming the infrared ablation layer described above using the coating liquid containing components for the intermediate layer and a solvent.

[Manufacturing method of flexographic printing plate]

The manufacturing method of the flexographic printing plate of the present embodiment includes a step of irradiating a flexographic printing raw plate including a support, a photosensitive resin composition layer disposed on the support, and an infrared ablation layer disposed on the photosensitive resin composition layer, with ultraviolet light from the side of the support; a step of irradiating the infrared ablation layer with infrared light to form a pattern by lithography; a step of irradiating the photosensitive resin composition layer with ultraviolet light for pattern exposure; and a step of removing the infrared ablation layer and the unexposed photosensitive resin composition layer.

Thereafter, a post exposure treatment step is performed, as needed, to obtain a flexographic printing plate (letterpress printing plate) formed from a cured product of the photosensitive resin composition layer.

In view of imparting peelability, the surface of the printing plate may be brought into contact with a liquid containing a silicone compound and/or fluorine compound.

The step of irradiating ultraviolet light from the support side can be performed by using a commonly used irradiation unit.

As the ultraviolet light, ultraviolet light with a wavelength of 150 to 500 nm can be used, and especially ultraviolet light with a wavelength of 300 to 400 nm is preferably used.

As a light source, a low pressure mercury lamp, a high pressure mercury lamp, an ultra-high pressure mercury lamp, a metal halide lamp, a xenon lamp, a zirconium lamp, a carbon arc lamp, and an ultraviolet light fluorescent lamp can be used, for example.

This step of irradiating ultraviolet light may be performed before the step of forming a pattern on the infrared ablation layer by lithography or may be performed after the step of forming a pattern by lithography.

When the flexographic printing raw plate has a cover film, the cover film is firstly peeled.

Thereafter, the infrared ablation layer is subjected to pattern irradiation with infrared light to form a mask on the photosensitive resin composition layer.

Examples of a preferable infrared laser include a Nd/YAG laser (1064 nm, for example) or a diode laser (830 nm, for example).

A suitable laser system for CTP plate production technology is commercially available, and diode laser system CDI Spark (ESKO GRAPHICS B.V.) can be used, for example.

This laser system comprises a rolling cylindrical drum for holding a flexographic printing raw plate, an IR laser irradiation device, and a layout computer, and image information is directly sent to the laser device from the layout computer.

After pattern drawing, the entire surface of the photosensitive resin composition layer is irradiated with ultraviolet light via a mask, as mentioned above.

While this irradiation can be performed in a state where the plate is attached to a laser cylinder, the plate is usually detached from the laser device and irradiated using a commonly used irradiation unit.

An irradiation unit as for ultraviolet light irradiation from the support side can be used as the irradiation unit.

When the flexographic printing raw plate of the present embodiment has an intermediate layer such as an oxygen inhibiting layer, adhesive layer, and the like, the amount of ultraviolet light absorbed by the intermediate layer serving as an oxygen inhibiting layer may be large and unignorable in the pattern exposure step. In that case, it is preferable that the irradiation amount of ultraviolet light be appropriately adjusted preliminarily taking into account the amount of ultraviolet light absorbed by the intermediate layer serving as an oxygen inhibiting layer.

Next, a development step is performed.

A conventionally known method can be applied in the development step.

Specifically, the flexographic printing raw plate is exposed as described above. Thereafter, an unexposed part is washed away with a solvent for solvent development or a cleaning liquid for water development. Alternatively, an unexposed part heated to 40°C to 200°C is brought into contact with a predetermined absorption layer capable of absorbing the unexposed part and the unexposed part is removed by removing the absorption layer.

Further, post exposure treatment is conducted, as needed, to manufacture a flexographic printing plate.

When an intermediate layer of an adhesive layer or oxygen inhibiting layer is provided between the infrared ablation layer and the photosensitive resin composition layer, the intermediate layer is simultaneously removed in the development step.

Examples of the development solvent used for developing the unexposed part by a solvent include, but not limited to, esters such as heptylacetate and 3-methoxybutyl acetate; hydrocarbons such as a petroleum fraction, toluene, and decalin; and a mixture of an alcohol such as propanol, butanol, or pentanol with a chlorine-based organic solvent such as tetrachloroethylene. Washout of the unexposed part is carried out by spraying from a nozzle or brushing with a brush.

As the cleaning liquid for water development, an alkaline aqueous solution or a neutral detergent can be used.

A surfactant can be preferably used for the cleaning liquid for water development.

The surfactant includes an anionic surfactant, an ampholytic surfactant, and a nonionic surfactant. These may be used singly, or two or more thereof may be mixed and used.

Examples of the anionic surfactant include, but not limited to, a sulfate salt, a higher alcohol sulfate, a higher alkyl ether sulfate salt, a sulfated olefin, alkyl benzene sulfonic acid salt, $\alpha$-olefin sulfonic acid salt, a phosphate salt, and dithiophosphate salt.

Examples of the ampholytic surfactant include, but not limited to, an amino acid type ampholytic surfactant, and a betaine type ampholytic surfactant.

Examples of the nonionic surfactant include, but not limited to, polyethylene glycol-type surfactants such as a higher alcohol ethylene oxide adduct, an alkylphenol ethylene oxide adduct, an aliphatic acid ethylene oxide adduct, a polyhydric alcohol fatty acid ester ethylene oxide adduct, a higher alkyl amine ethylene oxide adduct, a fatty acid amide ethylene oxide adduct, and a polypropylene glycol ethylene oxide adduct; and polyhydric alcohol type surfactants such as a glycerol fatty acid ester, a pentaerythritol fatty acid ester, fatty acid esters of sorbitol and sorbitane, alkyl esters of a polyhydric alcohol, and fatty acid amides of an alkanol amine.

In addition, the alkaline aqueous solution contains a pH adjuster.

The pH adjuster may be an organic material or an inorganic material but is preferably a pH adjuster capable of adjusting the pH value to 9 or higher. Examples of the pH adjuster include, but not limited to, sodium hydroxide, sodium carbonate, potassium carbonate, sodium silicate, sodium metasilicate, and sodium succinate.

The absorption layer for heat development includes nonwoven fabric material, paper material, fiber fabric, open cell foam, and porous material.

The absorption layer is preferably nonwoven fabric material of nylon, polyester, polypropylene, polyethylene, or a combination of any of these nonwoven fabric materials. The absorption layer is especially preferably a continuous nonwoven web of nylon or polyester.

Examples

Hereinafter, the present invention will be described in detail with reference to specific working examples and comparative examples. However, the present invention is not limited to the following examples at all.

[Manufacturing Example 1]

(Synthesis of hydrophilic copolymer)

To a pressure resistant reaction vessel provided with a stirring device and a jacket for temperature adjustment were initially added 125 parts by mass of water and, as a reactive emulsifier, 2 parts by mass of "ADEKA REASOAP" (manufactured by ADEKA Corporation; an ammonium salt of ($\alpha$-sulfo(1-nonylphenoxy)methyl-2-(2-propenyloxy)ethoxy-poly(oxy-1,2-ethanediyl)). The inside temperature was increased to 80°C; and an oil-based mixture liquid consisting of 2 parts by mass of t-dodecyl mercaptan and a monomer mixture consisting of 10 parts by mass of styrene, 60 parts by mass of butadiene, 23 parts by mass of butyl acrylate, 5 parts by mass of methacrylic acid, and 2 parts by mass of acrylic acid and an aqueous solution consisting of 28 parts by mass of water, 1.2 parts by mass of sodium peroxodisulfate, and 0.2 parts by mass of sodium hydroxide, and 2 parts by mass of an ammonium salt of ($\alpha$-sulfo(1-nonylphenoxy)methyl-2-(2-propenyloxy)ethoxy-poly(oxy-1,2-ethanediyl) were added to the reaction vessel over five hours and six hours, respectively, at a constant flow rate.

Thereafter, the temperature was continuously kept at 80°C for one hour to complete polymerization reaction and obtain a copolymer latex, followed by cooling.

Furthermore, pH of the produced copolymer latex was adjusted to 7 by sodium hydroxide, unreacted monomers were then removed by a steam stripping method followed by filtration with a 200 mesh metallic mesh, and the solid concentration of the filtrate was finally adjusted to 40% by mass to obtain an aqueous dispersion of a hydrophilic copolymer.

The obtained aqueous dispersion of the hydrophilic copolymer was dried up by a vacuum dryer at 50°C to consequently remove water therefrom to thereby obtain the hydrophilic copolymer.

[Manufacturing Example 2]

(Production of base film (support))

As a solution for an adhesive layer to coat a support (base film), 55 parts by mass of Tufprene 912 (manufactured by Asahi Kasei Corp., trade name), which is a block copolymer of styrene and 1,3-butadiene, 38 parts by mass of paraffin oil (average carbon number: 33, average molecular weight: 470, and density at 15°C: 0.868), 2.5 parts by mass of 1,9-nonanediol diacrylate, 1.5 parts by mass of 2,2-dimethoxy-phenylacetophenone, 3 parts by mass of EPOXY ESTER 3000M (manufactured by Kyoeisha Chemical Co., Ltd., trade name), and 1.5 parts by mass of VALIFAST YELLOW-3150 (manufactured by ORIENT CHEMICAL INDUSTRIES CO., LTD., trade name) were dissolved in toluene to obtain a solution with a solid content of 25%.

Thereafter, the obtained solution was applied to one side of a polyester film having a thickness of 100 $\mu$m using a knife coater so as to achieve an ultraviolet transmittance (UV transmittance) of 10% followed by drying at 80°C for one minute to obtain a support (base film) having an adhesive layer.

The UV transmittance of the support was calculated from transmission intensity measured by UV illuminometer MO-2 model (manufactured by ORC MANUFACTURING CO., LTD., trade name, UV-35 filter) using ultraviolet light exposure apparatus AFP-1500 (manufactured by Asahi Kasei Corp., trade name).

[Manufacturing Example 3]

(Production of stack for forming infrared ablation layer)

A coating liquid for an infrared ablation layer was obtained by mixing, as an infrared absorber, 100 parts by mass of carbon black (CB); as a dispersant, 20 parts by mass of Solsperse 39000 (manufactured by The Lubrizol Corporation, trade name, base number: 30 mgKOH/g); as a binder polymer, 80 parts by mass of Tufftec H1051 (manufactured by Asahi Kasei Corp., trade name), which was a hydrogenated product of a styrene-butadiene-styrene copolymer elastomer; and 600 parts by mass of toluene.

This coating liquid for an infrared ablation layer was applied onto a PET film with a thickness of 100 $\mu$m, which would be a cover film, to form a coating so that the film thickness after drying became 3 $\mu$m, and the formed coating was subjected to drying treatment for two minutes at 90°C to obtain a stack for forming an infrared ablation layer which was a stack of an infrared ablation layer and a cover film.

[Example 1]

(Production of flexographic printing raw plate)

After mixing 32 parts by mass of the hydrophilic copolymer obtained in [Manufacturing Example 1] described above and 28 parts by mass of a styrene-butadiene-styrene copolymer [D-KX405: manufactured by Kraton Corporation] at 140°C using a pressure kneader, a liquid mixture of 32 parts by mass of a liquid polybutadiene [LBR-352: manufactured by Kuraray Co., Ltd.], 8 parts by mass of 1,9-nonanediol diacrylate, 5 parts by mass of 1,6-hexanediol dimethacrylate, 2 parts by mass of 2,2-dimethoxy-phenylacetophenone, 1 part by mass of 2,6-di-t-butyl-p-cresol, and 1 part by mass of carbinol-modified silicone oil [KF-6000: manufactured by Shin-Etsu Chemical Co., Ltd.] was added little by little over 15 minutes, and additional kneading was carried out for 20 minutes after completion of addition to obtain a photosensitive resin composition 1.

Thereafter, the photosensitive resin composition 1 was put into an extrusion molding machine, the base film (support) obtained in [Manufacturing Example 2] described above was laminated on one face of the photosensitive resin composition 1 extruded from a T-shaped die and molded, a mold release film (manufactured by Mitsubishi Chemical Corporation, DIAFOIL MRV100) was laminated on the face of the photosensitive resin composition layer opposed to the side on which the support is laminated to obtain a stack of the support and the photosensitive resin composition layer 1.

Thereafter, the mold release film was peeled, and the stack for forming an infrared ablation layer obtained in [Manufacturing Example 3] described above was laminated so that the infrared ablation layer contacted the photosensitive resin composition layer to obtain a flexographic printing raw plate.

[Example 2]

AJISPER PB881 (manufactured by Ajinomoto Fine-Techno Co., Inc., trade name, base number: 17 mgKOH/g) was used as a dispersant instead of Solsperse 39000, and Asaflex 810 (manufactured by Asahi Kasei Corp., trade name), which was a styrene-butadiene-styrene copolymer elastomer, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 3]

DISPARLON DA-703-50 (manufactured by Kusumoto Chemicals, Ltd., trade name, base number: 20 mgKOH/g) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Example 4]

Solsperse 37500 (manufactured by The Lubrizol Corporation, trade name, base number: 9 mgKOH/g) was used as a dispersant instead of Solsperse 39000, and Tufprene 315 (manufactured by Asahi Kasei Corp., trade name), which was a styrene-butadiene-styrene copolymer elastomer, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 5]

Solsperse 28000 (manufactured by The Lubrizol Corporation, trade name, base number: 45 mgKOH/g) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Example 6]

Solsperse 71000 (manufactured by The Lubrizol Corporation, trade name, base number: 77 mgKOH/g) was used as a dispersant instead of Solsperse 39000, and Asaflex 810 (manufactured by Asahi Kasei Corp., trade name), which was a styrene-butadiene-styrene copolymer elastomer, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 7]

Solsperse 11200 (manufactured by The Lubrizol Corporation, trade name, base number: 39 mgKOH/g) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Example 8]

AJISPER PB881 (manufactured by Ajinomoto Fine-Techno Co., Inc., trade name, base number: 17 mgKOH/g) was used as a dispersant instead of Solsperse 39000, and RB810 (manufactured by JSR Corporation, trade name), which was a syndiotactic polybutadiene elastomer, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 9]

ALFLOW-H-50SJ (manufactured by NOF CORPORATION, Inc., trade name, base number: 12 mgKOH/g) was used as a dispersant instead of Solsperse 39000, and Tufprene 315 (manufactured by Asahi Kasei Corp., trade name), which was a styrene-butadiene-styrene copolymer elastomer, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 10]

At the time of preparing the coating liquid for an infrared ablation layer described in [Manufacturing Example 3] in manufacturing the flexographic printing raw plate, 100 parts by mass of carbon black; as a dispersant, 20 parts by mass of Solsperse 39000 (manufactured by The Lubrizol Corporation, trade name, base number: 30 mgKOH/g); as a binder polymer, 50 parts by mass of Tufftec H1051 (manufactured by Asahi Kasei Corp., trade name), which was a hydrogenated product of a styrene-butadiene-styrene copolymer elastomer, and 30 parts by mass of ARUFON UC-3510 (manufactured by TOAGOSEI CO., LTD., trade name), which was acid-modified acrylic resin; and 600 parts by mass of toluene were mixed to obtain a coating liquid for an infrared ablation layer. Except for this, the same conditions as in [Example 1] were applied to obtain a flexographic printing raw plate.

[Example 11]

At the time of preparing the coating liquid for an infrared ablation layer described in [Manufacturing Example 3] in manufacturing the flexographic printing raw plate, 100 parts by mass of carbon black; as a dispersant, 20 parts by mass of Solsperse 11200 (manufactured by The Lubrizol Corporation, trade name, base number: 39 mgKOH/g); as a binder polymer, 50 parts by mass of ARUFON UC-3000 (manufactured by TOAGOSEI CO., LTD., trade name), which was acid-modified acrylic resin and 30 parts by mass of Tufftec H1051 (manufactured by Asahi Kasei Corp., trade name), which was a hydrogenated product of a styrene-butadiene-styrene copolymer elastomer; and 600 parts by mass of toluene were mixed to obtain a coating liquid for an infrared ablation layer. Except for this, the same conditions as in [Example 1] were applied to obtain a flexographic printing raw plate.

[Example 12]

50 parts by mass of ε-caprolactam, 40 parts by mass of N,N-di(y-aminopropyl)piperazine adipate, 10 parts by mass of 1,3-bis(aminomethyl)cyclohexane adipate, and 100 parts by mass of water were heated in a nitrogen atmosphere in an autoclave. After pressurized reaction at an inner pressure of 10 kg/cm$^2$ for two hours, reaction was further carried out at atmospheric pressure for one hour to obtain a tertiary nitrogen-containing polyamide.
At the time of preparing the coating liquid for an infrared ablation layer described in [Manufacturing Example 3] in manufacturing the flexographic printing raw plate, 100 parts by mass of carbon black; as a dispersant, 20 parts by mass of Solsperse 37500 (manufactured by The Lubrizol Corporation, trade name, base number: 9 mgKOH/g); as a binder polymer, 50 parts by mass of S-LEC BM-5 (manufactured by SEKISUI CHEMICAL CO., LTD., trade name), which was butyral resin, and 30 parts by mass of the above-described tertiary nitrogen-containing polyamide; and 600 parts by mass of toluene were mixed to obtain a coating liquid for an infrared ablation layer. Except for this, the same conditions as in [Example 1] were applied to obtain a flexographic printing raw plate.

[Example 13]

AJISPER PB881 (manufactured by Ajinomoto Fine-Techno Co., Inc., trade name, base number: 17 mgKOH/g) was used as a dispersant instead of Solsperse 39000, and MACROMELT 6900 (manufactured by Henkel Japan Ltd., trade name), which was a polyamide, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 14]

DISPARLON DA-703-50 (manufactured by Kusumoto Chemicals, Ltd., trade name, base number: 20 mgKOH/g) was used as a dispersant instead of Solsperse 39000, and GOHSENOL GH-22 (manufactured by the Nippon Synthetic Chemical Industry Co., Ltd., trade name, saponification degree: 87 mol%), which is a polyvinyl alcohol, was used as a binder polymer instead of Tufftec H1051, at the time of preparing the coating liquid for an infrared ablation layer described in [Manufacturing Example 3] in manufacturing the flexographic printing raw plate. Except for these, the same conditions as in [Example 1] were applied to obtain a flexographic printing raw plate.

[Example 15]

At the time of preparing the coating liquid for an infrared ablation layer described in [Manufacturing Example 3] in manufacturing the flexographic printing raw plate, as an infrared absorber, 100 parts by mass of carbon black; as a dispersant, 0.3 parts by mass of Solsperse 39000 (manufactured by The Lubrizol Corporation, trade name, base number: 30 mgKOH/g); as a binder polymer, 80 parts by mass of Tufftec H1051 (manufactured by Asahi Kasei Corp., trade name), which was a hydrogenated product of a styrene-butadiene-styrene copolymer elastomer; and 600 parts by mass of toluene were mixed to obtain a coating liquid for an infrared ablation layer.
Except for this, the same conditions as in [Example 1] were applied to obtain a flexographic printing raw plate.

[Example 16]

At the time of preparing the coating liquid for an infrared ablation layer described in [Manufacturing Example 3] in manufacturing the flexographic printing raw plate, as an infrared absorber, 100 parts by mass of carbon black; as a dispersant, 38 parts by mass of Solsperse 39000 (manufactured by The Lubrizol Corporation, trade name, base number: 30 mgKOH/g); as a binder polymer, 80 parts by mass of Tufftec H1051 (manufactured by Asahi Kasei Corp., trade name), which was a hydrogenated product of a styrene-butadiene-styrene copolymer elastomer; and 600 parts by mass of toluene were mixed to obtain a coating liquid for an infrared ablation layer.
Except for this, the same conditions as in [Example 1] were applied to obtain a flexographic printing raw plate.

[Example 17]

At the time of preparing the coating liquid for an infrared ablation layer described in [Manufacturing Example 3] in manufacturing the flexographic printing raw plate, as an infrared absorber, 100 parts by mass of carbon black; as a dispersant, 60 parts by mass of Solsperse 39000 (manufactured by The Lubrizol Corporation, trade name, base number: 30 mgKOH/g); as a binder polymer, 80 parts by mass of Asaflex 810 (manufactured by Asahi Kasei Corp., trade name), which was a hydrogenated product of a styrene-butadiene-styrene copolymer elastomer; and 600 parts by mass of toluene were mixed to obtain a coating liquid for an infrared ablation layer. Except for this, the same conditions as in [Example 1] were applied to obtain a flexographic printing raw plate.

[Example 18]

In manufacturing the flexographic printing raw plate, a polyvinyl alcohol solution consisting of 1 part by mass of GOHSENOL GH-22 (manufactured by the Nippon Synthetic Chemical Industry Co., Ltd., trade name, saponification degree: 87 mol%), 20 parts by mass of water, and 10 parts by mass of ethanol was applied onto the stack for forming an infrared ablation layer obtained in [Manufacturing Example 3] described above to form a coating so that the film thickness was 1 $\mu$m, followed by drying to form an oxygen inhibiting layer.
Furthermore, the stack of the oxygen inhibiting layer, infrared ablation layer, and cover film obtained as above was laminated at 120°C on the stack of the support and the photosensitive resin composition layer 1 described in [Example 1] so that the oxygen inhibiting layer contacted the photosensitive resin composition layer to obtain a flexographic printing raw plate.

[Example 19]

At the time of preparing the coating liquid for an infrared ablation layer described in [Manufacturing Example 3] in manufacturing the flexographic printing raw plate, 100 parts by mass of nickel-dithiolene complex B4360 (manufactured by Tokyo Chemical Industry Co., Ltd., trade name) as an infrared absorber; 20 parts by mass of Solsperse 37500 (manufactured by The Lubrizol Corporation, trade name, base number: 9 mgKOH/g) as a dispersant; 80 parts by mass of Tufprene 315 (manufactured by Asahi Kasei Corp., trade name), which was a styrene-butadiene-styrene copolymer elastomer, as a binder polymer; and 600 parts by mass of toluene were mixed to obtain a coating liquid for an ablation layer. Except for this, the same conditions as in [Example 1] were applied to obtain a flexographic printing raw plate.

[Example 20]

In manufacturing the photosensitive resin composition, after mixing 60 parts by mass of a styrene-butadiene-styrene copolymer [D-KX405: manufactured by Kraton Corporation] at 180°C using a pressure kneader, a liquid mixture of 32 parts by mass of a liquid polybutadiene [LBR-352: manufactured by Kuraray Co., Ltd.], 8 parts by mass of 1,9-nonanediol diacrylate, 5 parts by mass of 1,6-hexanediol dimethacrylate, 2 parts by mass of 2,2-dimethoxy-phenylacetophenone, 1 part by mass of 2,6-di-t-butyl-p-cresol, and 1 part by mass of amino-modified silicone oil [KF-8000: manufactured by Shin-Etsu Chemical Co., Ltd.] was added little by little over 15 minutes, and additional kneading was carried out for 20 minutes after completion of addition to obtain a photosensitive resin composition 2.
Except for this, the same conditions as in [Example 1] were applied to obtain a flexographic printing raw plate.

[Example 21]

In manufacturing the flexographic printing raw plate, a polyamide solution consisting of 10 parts by mass of TECHNOMELT PA6801 (manufactured by Henkel Japan Ltd., trade name), 45 parts by mass of toluene, and 45 parts by mass of 2-propanol was applied onto the stack for forming an infrared ablation layer obtained in [Manufacturing Example 3] described above to form a coating so that the film thickness was 5 μm,followed by drying to form an oxygen inhibiting layer.

Furthermore, the stack of the oxygen inhibiting layer, infrared ablation layer, and cover film obtained as above was laminated at 120°C on the stack of the support obtained in [Manufacturing Example 2] described above and used in [Example 1] described above and the photosensitive resin composition layer 2 described in [Example 20] so that the oxygen inhibiting layer contacted the photosensitive resin composition layer to obtain a flexographic printing raw plate.

[Comparative Example 1]

DISPARLON DA-375 (manufactured by Kusumoto Chemicals, Ltd., trade name, base number: 0 mgKOH/g) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Comparative Example 2]

Solsperse 18000 (manufactured by The Lubrizol Corporation, trade name, base number: 2 mgKOH/g) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Comparative Example 3]

Solsperse 13300 (manufactured by The Lubrizol Corporation, trade name, base number: 123 mgKOH/g) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Comparative Example 4]

SLIPACKS O (manufactured by Nihon Kasei CO., LTD., trade name) was used as a dispersant instead of Solsperse 39000 at the time of preparing the coating liquid for an infrared ablation layer described in [Manufacturing Example 3] in manufacturing the flexographic printing raw plate. Except for this, the same conditions as in [Example 1] were applied to obtain a flexographic printing raw plate.

[Comparative Example 5]

50 parts by mass of ε-caprolactam, 40 parts by mass of N,N-di(y-aminopropyl)piperazine adipate, 10 parts by mass of 1,3-bis(aminomethyl)cyclohexane adipate, and 100 parts by mass of water were heated in a nitrogen atmosphere in an autoclave. After pressurized reaction at an inner pressure of 10 kg/cm$^2$ for two hours, reaction was further carried out at atmospheric pressure for one hour to obtain a tertiary nitrogen-containing polyamide.

At the time of preparing the coating liquid for an infrared ablation layer described in [Manufacturing Example 3] in manufacturing the flexographic printing raw plate, 100 parts by mass of carbon black; as a binder polymer, 50 parts by mass of S-LEC BM-5 (manufactured by SEKISUI CHEMICAL CO., LTD., trade name), which was butyral resin; 30 parts by mass of the above-described tertiary nitrogen-containing polyamide; and 300 parts by mass of toluene were mixed to obtain a coating liquid for an ablation layer. Except for these, the same conditions as in [Example 1] were applied to obtain a flexographic printing raw plate.

[Measurement of physical properties]

<Method for measuring base number of dispersant>

Base numbers of the dispersants were measured according to the potentiometric titration method (base number-perchloric acid method) defined in JIS K 2501 (2003).

Specifically, the amount of perchloric acid required to neutralize basic components contained in 1 g of a sample was measured. The base number is represented by the number of milligrams of potassium hydroxide (KOH) equivalent to the amount of perchloric acid.

When the dispersant was a commercial product, the base number of catalog data for the commercial product was preferentially adopted.

Although units are not shown in Table 1 below for the purpose of convenience, units for the base numbers of the dispersants are all mgKOH/g.

<Method for measuring weight average molecular weight by gel permeation column chromatography (GPC)>

Wight average molecular weights (Mw) of the dispersants were measured using the following device under the following conditions.

In Table 1 below, a low molecular weight sample having a weight average molecular weight of less than 1000, the peak of which was embedded in the peak of the solvent and therefore was not discriminated, is indicated by the expression "less than 1000".

Device: HLC- -8220 GPC manufactured by Tosoh Corporation
Column: the following four columns were connected in series for separation.
TSKgel GMH XL manufactured by Tosoh Corporation + TSKgel GMH XL manufactured by Tosoh Corporation + TSKgel GMH XLL manufactured by Tosoh Corporation + TSKgel GMH XLL manufactured by Tosoh Corporation
Column temperature: 40°C
Solvent: tetrahydrofuran
Detector: RI
Calibration curve: standard polystyrene

<Method for measuring SP values of dispersant and binder polymer, ΔSP value>

SP values of the dispersants and binder polymers were measured by a turbidimetric titration method.

First, into a solution with a given concentration of a dispersant or binder polymer in a good solvent with a known SP value, a poor solvent with an SP value lower than that of the good solvent was dropped, and the volume of the poor solvent at which a solute started to precipitate was measured. Subsequently, into a newly prepared solution of a sample with an unknown SP value in a good solvent with a known SP value, a poor solvent with an SP value higher than that of the good solvent was dropped, and the volume of the poor solvent at which a solute started to precipitate was measured. The volumes of the respective poor solvents measured herein were applied to formula (2) below to obtain the SP value:

$$\delta \; = \; (V_{ml}^{1/2} \cdot \delta_{ml} \; + \; V_{mh}^{1/2} \cdot \delta_{mh}) \, / \, (V_{ml}^{1/2} \; + \; V_{mh}^{1/2}) \quad \cdots \quad (2)$$

wherein, $\delta$ is an SP value of the dispersant or binder polymer, $V_{ml}$ is the volume of the poor solvent with a lower SP value, $V_{mh}$ is the volume of the poor solvent with a higher SP value, $\delta_{ml}$ is the SP value of the poor solvent with a lower SP value, and $\delta_{mh}$ is the SP value of the poor solvent with a higher SP value.

The measurement was performed using the following good solvents and poor solvents and the respective SP values.

Good solvent: toluene (SP value: 8.9 $[(cal/cm^3)^{1/2}]$)
p-xylene (SP value: 8.7 $[(cal/cm^3)^{1/2}]$)
butyl acetate (SP value: 8.5 $[(cal/cm^3)^{1/2}]$)
ethyl acetate (SP value: 9.1 $[(cal/cm^3)^{1/2}]$)
acetone (SP value: 9.8 $[(cal/cm^3)^{1/2}]$)
Poor solvent: n-hexane (SP value: 7.2 $[(cal/cm^3)^{1/2}]$)
ethanol (SP value: 12.9 $[(cal/cm^3)^{1/2}]$)
water (SP value: 23.4 $[(cal/cm^3)^{1/2}]$)

Although units are not shown in Table 1 below for the purpose of convenience, units for the SP values are all $[(cal/cm^3)^{1/2}]$.

[Characteristic evaluation]

<Evaluation on peelability>

Each of the flexographic printing raw plates obtained in [Examples] and [Comparative Examples] described above was cut into a piece with a size of 10 cm × 15 cm to obtain samples.

Among these samples, a sample for initial evaluation was subjected to measurement of peeling force by the method described later within 72 hours after preparing the sample, and a sample for evaluation after aging was subjected to measurement of peeling force by the method described later after storing the sample in thermohygrostat PH-3K (manufactured by ESPEC CORP.) set at a temperature of 40°C and a relative humidity of 10% RH for one month.

Peeling force was measured by peeling the cover film at a crosshead speed of 50 mm/min in the direction of 180° using tensile tester Autograph AGS-X100N (manufactured by SHIMADZU CORPORATION).

The samples were evaluated according to the following 5-point scale on the basis of the results thereof.

In the following evaluation, the larger the score is, the more preferable the sample is, and those given a score of 3 or more can be practically used without any problem.

5: The maximum value of peeling force is smaller than 20 gf/10 cm.
4: The maximum value of peeling force is 20 gf/10 cm or more and smaller than 30 gf/10 cm.
3: The maximum value of peeling force is 30 gf/10 cm or more and smaller than 50 gf/10 cm.
2: The maximum value of peeling force is 50 gf/10 cm or more.
1: The infrared ablation layer is transferred to the cover film side.

<Pin hole (PH) evaluation>

Each of the flexographic printing raw plates obtained in [Examples] and [Comparative Examples] described above was cut into five pieces with a size of 10 cm $\times$ 10 cm to obtain samples.

The cover film of the infrared ablation layer of each of these samples was removed, each sample was then placed on a light table, and microscopic inspection was conducted thereon.

The number of pin holes with a long diameter of 20 $\mu$m or more in the infrared ablation layer was counted, and an averaged value was taken to calculate a value (number of pin holes /m$^2$), which was evaluated on the following 5-point scale. In the evaluation, the larger the score is, the more preferable the sample is, and those given a score of 3 or more can be practically used without any problem.

5: The number of pin holes is less than 2 (number of pin holes /m$^2$) on average.
4: The number of pin holes is 2 (number of pin holes /m$^2$) or more and less than 5 (number of pin holes /m$^2$) on average.
3: The number of pin holes is 5 (number of pin holes /m$^2$) or more and less than 10 (number of pin holes /m$^2$) on average.
2: The number of pin holes is 10 (number of pin holes /m$^2$) or more and less than 20 (number of pin holes /m$^2$) on average.
1: The number of pin holes is 20 (number of pin holes /m$^2$) or more on average.

[Table 1]

| | Infrared ablation layer | | | | | | | | | | | | | | Photosensitive resin layer | Evaluation items | | |
|---|---|---|---|---|---|---|---|---|---|---|---|---|---|---|---|---|---|---|
| | Infrared absorber | | Dispersant | | | | | Binder polymer ① | | | | Binder polymer ② | | | | (1) Peelability | | (2) PH |
| | Material | Amount added | Material trade name | Amount added | Base number | Mw | SP value | Material trade name | Amount added | SP value | △SP value | Material | Amount added | SP value | | Initial | After one month | |
| | | Parts by mass | | Parts by mass | | | | | Parts by mass | | | | Parts by mass | | | | | |
| Example 1 | CB | 100 | Solsperse 39000 | 20 | 30.0 | 2800 | 11.5 | Tufftec H1051 | 80 | 9.4 | 2.1 | | | | Photosensitive resin composition 1 | 5 | 5 | 5 |
| Example 2 | CB | 100 | AJISPER PB881 | 20 | 17.0 | 1500 | 12.1 | Asaflex 810 | 80 | 9.9 | 2.2 | | | | Photosensitive resin composition 1 | 5 | 4 | 5 |
| Example 3 | CB | 100 | DISPARLON DA-703-50 | 20 | 20.0 | 3800 | 11.0 | Tufftec H1051 | 80 | 9.4 | 1.6 | | | | Photosensitive resin composition 1 | 5 | 4 | 4 |
| Example 4 | CB | 100 | Solsperse 37500 | 20 | 9.0 | 7300 | 11.6 | Tufprene 315 | 80 | 8.7 | 2.9 | | | | Photosensitive resin composition 1 | 4 | 4 | 5 |
| Example 5 | CB | 100 | Solsperse 28000 | 20 | 45.0 | 3000 | 7.8 | Tufftec H1051 | 80 | 9.4 | -1.6 | | | | Photosensitive resin composition 1 | 5 | 4 | 5 |
| Example 6 | CB | 100 | Solsperse 71000 | 20 | 77.0 | 2900 | 11.6 | Asaflex 810 | 80 | 9.9 | 1.7 | | | | Photosensitive resin composition 1 | 4 | 4 | 5 |
| Example 7 | CB | 100 | Solsperse 11200 | 20 | 39.0 | 3000 | 9.5 | Tufftec | 80 | 9.4 | 0.1 | H1051 | | | Photosensitive resin composition 1 | 5 | 3 | 4 |
| Example 8 | CB | 100 | AJISPER PB881 | 20 | 17.0 | 1500 | 12.1 | JSR RB810 | 80 | 7.7 | 4.4 | | | | Photosensitive resin composition 1 | 4 | 3 | 3 |

| | Infrared absorber Material | Amount added (Parts by mass) | Dispersant Material trade name | Amount added (Parts by mass) | Base number | Mw | SP value | Binder polymer ① Material trade name | Amount added (Parts by mass) | SP value | ΔSP value | Binder polymer ② Material | Amount added (Parts by mass) | SP value | Photosensitive resin layer | (1) Peelability Initial | After one month | (2) PH |
|---|---|---|---|---|---|---|---|---|---|---|---|---|---|---|---|---|---|---|
| Example 9 | CB | 100 | ALFLOW-H-50SJ | 20 | 12.0 | less than 1000 | 9.5 | Tufprene 315 | 80 | 8.7 | 0.8 | | | | Photosensitive resin composition 1 | 3 | 3 | 3 |
| Example 10 | CB | 100 | Solsperse 39000 | 20 | 30.0 | 2800 | 11.5 | Tufftec | 50 | 9.4 | 2.1 | H1051 ARUFON UC3510 | 30 | 9.9 | Photosensitive resin composition 1 | 5 | 5 | 5 |
| Example 11 | CB | 100 | Solsperse 11200 | 20 | 39.0 | 3000 | 9.5 | ARUFON US3000 | 50 | 11.7 | -2.2 | Tufftec H1051 | 30 | 9.4 | Photosensitive resin composition 1 | 5 | 5 | 4 |
| Example 12 | CB | 100 | Solsperse 37500 | 20 | 9.0 | 7300 | 11.6 | S-LEC BM-5 | 50 | 12.1 | -0.5 | Tertiary nitrogen-containing polyamide | 30 | 14.5 | Photosensitive resin composition 1 | 3 | 3 | 4 |
| Example 13 | CB | 100 | AJISPER PB881 | 20 | 17.0 | 1500 | 12.1 | MACROMEL 6900 | 80 | 13.5 | -1.4 | T | | | Photosensitive resin composition 1 | 3 | 3 | 4 |
| Example 14 | CB | 100 | DISPARLON DA-703-50 | 20 | 20.0 | 3800 | 11.0 | GOHSENOL GH-22 | 80 | 15.3 | -4.3 | | | | Photosensitive resin composition 1 | 3 | 3 | 4 |
| Example 15 | CB | 100 | Solsperse 39000 | 0.3 | 30.0 | 2800 | 11.5 | Tufftec H1051 | 80 | 9.4 | 2.1 | | | | Photosensitive resin composition 1 | 4 | 3 | 3 |

| | Infrared ablation layer | | | | | | | | | | | | | | Photosensitive resin layer | Evaluation items | | |
|---|---|---|---|---|---|---|---|---|---|---|---|---|---|---|---|---|---|---|
| | Infrared absorber | | Dispersant | | | | | Binder polymer ① | | | | Binder polymer ② | | | | (1) Peelability | | (2) PH |
| | Material | Amount added | Material trade name | Amount added | Base number | Mw | SP value | Material trade name | Amount added | SP value | ΔSP value | Material | Amount added | SP value | | Initial | After one month | |
| | | Parts by mass | | Parts by mass | | | | | Parts by mass | | | | Parts by mass | | | | | |
| Example 16 | CB | 100 | Solsperse 39000 | 38 | 30.0 | 2800 | 11.5 | Tufftec H1051 | 80 | 9.4 | 2.1 | | | | Photosensitive resin composition 1 | 5 | 5 | 4 |
| Example 17 | CB | 100 | Solsperse 39000 | 60 | 30.0 | 2800 | 11.5 | Asaflex 810 | 80 | 9.9 | 1.6 | | | | Photosensitive resin composition 1 | 4 | 4 | 3 |
| Example 18 | CB | 100 | Solsperse 39000 | 20 | 30.0 | 2800 | 11.5 | Tufftec H1051 | 80 | 9.4 | 2.1 | | | | Photosensitive resin composition 1 | 5 | 5 | 5 |
| Example 19 | B4360 | 100 | Solsperse 37500 | 20 | 9.0 | 7300 | 11.6 | Tufprene 315 | 80 | 8.7 | 2.9 | | | | Photosensitive resin composition 1 | 4 | 4 | 3 |
| Example 20 | CB | 100 | Solsperse 39000 | 20 | 30.0 | 2800 | 11.5 | Tufftec H1051 | 80 | 9.4 | 2.1 | | | | Photosensitive resin composition 2 | 5 | 5 | 5 |
| Example 21 | CB | 100 | Solsperse 39000 | 20 | 30.0 | 2800 | 11.5 | Tufftec H1051 | 80 | 9.4 | 2.1 | | | | Photosensitive resin composition 2 | 5 | 5 | 5 |
| | | | | | | | | | | | | | | | | | | |
| Comparative Example 1 | CB | 100 | DISPARLON DA-375 | 20 | 0.0 | 2500 | 11.4 | Tufftec H1051 | 80 | 9.0 | 2.4 | | | | Photosensitive resin composition 1 | 1 | 1 | 2 |
| Comparative Example 2 | CB | 100 | Solsoperse 18000 | 20 | 2.0 | 3000 | 8.1 | Tufftec H1051 | 80 | 9.0 | -0.9 | | | | Photosensitive resin composition 1 | 2 | 1 | 2 |

(continued)

| | Infrared ablation layer | | | | | | | | | | | | | | Photosensitive resin layer | Evaluation items | | |
| | Infrared absorber | | Dispersant | | | | | Binder polymer ① | | | | Binder polymer ② | | | | (1) Peelability | | (2) PH |
| | Material | Amount added | Material trade name | Amount added | Base number | Mw | SP value | Material trade name | Amount added | SP value | △SP value | Material | Amount added | SP value | | Initial | After one month | |
| | | Parts by mass | | Parts by mass | | | | | Parts by mass | | | | Parts by mass | | | | | |
| Comparative Example 3 | CB | 100 | Solsoperse 13300 | 20 | 123.0 | 2800 | 9.9 | Tufftec H1051 | 80 | 9.0 | 0.9 | | | | Photosensitive resin composition 1 | 1 | 1 | 4 |
| Comparative Example 4 | CB | 100 | SLIPACKS O | 20 | 3.0 | less than 1000 | 9.6 | Tufftec H1051 | 80 | 9.0 | 0.6 | | | | Photosensitive resin composition 1 | 2 | 1 | 2 |
| Comparative Example 5 | CB | 100 | | | | | | S-LEC BM-5 | 50 | 12.1 | | Tertiary nitrogen-containing polyamide | 30 | 14.5 | Photosensitive resin composition 1 | 3 | 1 | 4 |

The present application is based on the Japanese patent application (Japanese Patent Application No. 2019-034366) filed to Japan Patent Office on February 27, 2019 and the Japanese patent application (Japanese Patent Application No. 2019-087410) filed to Japan Patent Office on May 7, 2019, and the contents thereof are incorporated herein by reference.

Industrial Applicability

The flexographic printing raw plate of the present invention has an infrared ablation layer excellent in pin hole resistance, has an easily peelable cover film on the infrared ablation layer, and has therefore industrial applicability in a field of general commercial printing such as films, labels, and cartons.

**Claims**

1. A flexographic printing raw plate comprising at least a support, a photosensitive resin composition layer, an infrared ablation layer, and a cover film sequentially stacked, wherein

   the infrared ablation layer contains an infrared absorber, a binder polymer, and a dispersant, and
   a base number of the dispersant is 5 to 100 mgKOH/g.

2. The flexographic printing raw plate according to claim 1, wherein
   an absolute value of a difference between solubility parameters (SP values) of the binder polymer and the dispersant is 0.3 to 4 $(cal/cm^3)^{1/2}$.

3. The flexographic printing raw plate according to claim 1 or 2, wherein
   the infrared absorber is carbon black.

4. The flexographic printing raw plate according to any one of claims 1 to 3, wherein
   a weight average molecular weight of the dispersant measured by gel permeation chromatography (GPC) in terms of standard polystyrene is 1000 or more and 10000 or less.

5. The flexographic printing raw plate according to any one of claims 1 to 4, wherein
   the infrared ablation layer contains 0.5 to 50 parts by mass of the dispersant per 100 parts by mass of the infrared absorber.

6. The flexographic printing raw plate according to any one of claims 1 to 5, wherein

   the binder polymer includes at least one selected from the group consisting of
   a thermoplastic elastomer including a copolymer of a monovinyl-substituted aromatic hydrocarbon monomer and a conjugated diene monomer, a hydrogenated product of the copolymer,
   a polyamide, a polybutyral, a polyvinyl alcohol, a poly(meth)acrylate, and a modified product or partially saponified product thereof.

7. The flexographic printing raw plate according to any one of claims 1 to 6, further comprising an intermediate layer including an adhesive layer or an oxygen inhibiting layer between the photosensitive resin composition layer and the infrared ablation layer.

8. A manufacturing method of a flexographic printing plate, comprising the steps of:

   irradiating the flexographic printing raw plate according to any one of claims 1 to 6 with ultraviolet light from a side of the support;
   irradiating the infrared ablation layer with infrared light to form a pattern by lithography,
   irradiating the photosensitive resin composition layer with ultraviolet light for pattern exposure, and
   removing unexposed parts of the infrared ablation layer and the photosensitive resin composition layer.

9. A manufacturing method of a flexographic printing plate, comprising the steps of:

   irradiating the flexographic printing raw plate according to claim 7 with ultraviolet light from a side of the support;

irradiating the infrared ablation layer with infrared light to form a pattern by lithography,
irradiating the photosensitive resin composition layer with ultraviolet light for pattern exposure, and
removing unexposed parts of the infrared ablation layer, the intermediate layer, and the photosensitive resin composition layer.

<table>
<tr><td colspan="2" align="center">**INTERNATIONAL SEARCH REPORT**</td><td>International application No.<br>PCT/JP2020/007295</td></tr>
</table>

A. CLASSIFICATION OF SUBJECT MATTER
B41N 1/12(2006.01)i; B41N 3/00(2006.01)i; G03F 7/00(2006.01)i; G03F
7/004(2006.01)i; G03F 7/032(2006.01)i; G03F 7/095(2006.01)i; G03F
7/11(2006.01)i
FI:     G03F7/004 504; G03F7/095; G03F7/00 502; G03F7/004 505; G03F7/032;
          B41N3/00; B41N1/12; G03F7/11
According to International Patent Classification (IPC) or to both national classification and IPC

B. FIELDS SEARCHED

Minimum documentation searched (classification system followed by classification symbols)
B41N1/12; B41N3/00; G03F7/00; G03F7/004; G03F7/032; G03F7/095; G03F7/11

Documentation searched other than minimum documentation to the extent that such documents are included in the fields searched
| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-80225 A (BASF DRUCKSYSTEME GMBH)<br>27.03.2001 (2001-03-27) claims, examples | 1-9 |
| X | JP 2002-14460 A (AGFA-GEVAERT NAAMLOZE<br>VENNOOTSCHAP) 18.01.2002 (2002-01-18) claims,<br>examples | 1-9 |
| X | JP 2001-356491 A (AGFA-GEVAERT NAAMLOZE<br>VENNOOTSCHAP) 26.12.2001 (2001-12-26) claims,<br>examples | 1-9 |

☐ Further documents are listed in the continuation of Box C.   ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>19 March 2020 (19.03.2020) | Date of mailing of the international search report<br>31 March 2020 (31.03.2020) |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

International application No.

PCT/JP2020/007295

| Patent Documents referred in the Report | Publication Date | Patent Family | Publication Date |
|---|---|---|---|
| JP 2001-80225 A | 27 Mar. 2001 | US 6521390 B1 claims, examples EP 1069475 A1 | |
| JP 2002-14460 A | 18 Jan. 2002 | US 2002/0009672 A1 claims, examples EP 1170121 A1 | |
| JP 2001-356491 A | 26 Dec. 2001 | US 20010038975 A1 claims, examples EP 1146392 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4080068 B
- JP 4200510 B
- JP 6232279 B
- JP 2018120131 A
- JP 55079437 A
- JP 58113537 A
- JP 50076055 A
- JP 53036555 A
- JP 58140737 A
- JP 4097154 A
- JP 2019034366 A
- JP 2019087410 A

**Non-patent literature cited in the description**

- **TAKAHASHI, NAMBA ; KOIKE, KOBAYASHI.** Kaimenkasseizai handobukku (Surfactant Handbook). Kougakutosho Ltd, 1972
- **J. BRANDUP ; E.H. IMMERGUT.** POLYMER HANDBOOK. John Wiley & Sons, 1989
- **OTSU.** Kaitei koubunshigousei no kagaku (Chemistry of polymer synthesis revised edition). Kagaku-Dojin Publishing Company, INC, 1979
- **J. BRANDUP ; E.H. IMMERGUT.** POLYMER HANDBOOK. John Willy & Sons, 1989
- *POLYMER ENGINEERING AND SCIENCE,* 1974, vol. 14, 147-154